(19) Europäisches Patentamt
European Patent Office
Office européen des brevets

(11) **EP 1 653 627 B1**

(12) **EUROPEAN PATENT SPECIFICATION**

(45) Date of publication and mention
of the grant of the patent:
**30.09.2009 Bulletin 2009/40**

(51) Int Cl.:
***G10L 21/02*** *(2006.01)*

(21) Application number: **04748093.4**

(22) Date of filing: **23.07.2004**

(86) International application number:
**PCT/JP2004/010886**

(87) International publication number:
**WO 2005/011127 (03.02.2005 Gazette 2005/05)**

(54) **AUDIO SIGNAL BAND EXPANSION APPARATUS AND METHOD**

Audiosignalband-expansionsvorrichtung und verfahren

APPAREIL ET PROCEDE D'ELARGISSEMENT DE BANDE DE SIGNAL AUDIO

(84) Designated Contracting States:
**DE GB**

(30) Priority: **29.07.2003 JP 2003281549**

(43) Date of publication of application:
**03.05.2006 Bulletin 2006/18**

(73) Proprietor: **Panasonic Corporation**
**Kadoma-shi**
**Osaka 571-8501 (JP)**

(72) Inventors:
• **EJIMA, Naoki**
 **Osaka 573-1102 (JP)**
• **IWATA, Kazuya**
 **Osaka 576-0033 (JP)**

(74) Representative: **Eisenführ, Günther**
**Eisenführ, Speiser & Partner**
**Patentanwälte Rechtsanwälte**
**Postfach 10 60 78**
**28060 Bremen (DE)**

(56) References cited:
**EP-A- 0 706 299**          **EP-A- 1 126 620**
**WO-A1-00/70769**        **JP-A- 9 018 351**
**JP-A- 9 023 162**          **JP-A- 2002 015 522**
**JP-A- 2002 252 562**     **JP-A- 2002 366 178**
**JP-A- 2002 372 993**     **JP-A- 2003 015 695**
**US-A1- 2002 121 999**

• **PATENT ABSTRACTS OF JAPAN vol. 2003, no. 05, 12 May 2003 (2003-05-12) & JP 2003 015695 A (MATSUSHITA ELECTRIC IND CO LTD), 17 January 2003 (2003-01-17)**
• **PATENT ABSTRACTS OF JAPAN vol. 1997, no. 05, 30 May 1997 (1997-05-30) & JP 09 023162 A (MATSUSHITA ELECTRIC IND CO LTD), 21 January 1997 (1997-01-21)**

**Description**

TECHNICAL FIELD

The present invention relates to an apparatus for extending a band of an audio signal, capable of improving sound quality of the audio signal reproduced by an audio equipment, in particular in a higher frequency range, and capable of reproducing such an audio signal comfortable to the human ear. In particular, the present invention relates to an audio signal band extending apparatus for extending a.band of an inputted audio signal by performing a digital processing on the inputted audio signal.

BACKGROUND ART

A method and and an apparatus (referred to as a prior art hereinafter) for extending a band of an audio signal are disclosed in, for example, a pamphlet of international application publication No. WO00/70769. According to the prior art, a higher harmonic wave component is generated based on an inputted audio signal, a level of the inputted audio signal is detected, and a noise signal, which is a random higher harmonic wave component, is generated independently of the inputted audio signal. Then, after a level of a generated noise signal is changed according to a detected level, a generated higher harmonic wave component is added to a level-changed noise signal, and a predetermined bandpass filtering processing is executed on a signal having an addition result. Further, the inputted audio signal is added to a signal on which the bandpass filtering processing has been executed while adjusting the level of the inputted audio signal, and a signal having an addition result is outputted as an outputted signal from the apparatus.

In EP 0 706 299 a method and an apparatus for reproducing audio signals is disclosed. Hereby the problem of unnaturalness in the quality of the reproduced sound is regarded which is caused when the frequency spectrum of the audio signal is decreased or cut off at an upper limit of the reproducible frequency or at an upper limit of audible frequency range. To achieve a desirable sound in people's audio sense, a random noise component and/or a higher harmonics component exceeding over the upper limit of the reproducible frequency range or the upper limit of the audible frequency range is added to the original audio signal in response to an output of the original audio signal.

DISCLOSURE OF INVENTION

According to the prior art, the noise signal, which is the random higher harmonic wave component, is generated independently of the inputted audio signal. Accordingly, it is necessary to adjust the level of the generated noise signal to that of the inputted audio signal. This requires level detection means and variable amplification and attenuation means for amplitude adjustment, and this leads to such a problem that a rising of an audio signal is delayed and the spectral continuity thereof becomes unnatural. Therefore, it is impossible to obtain a satisfactory audio signal in terms of both frequency characteristic and time characteristic.

An object of the present invention is to provide an audio signal band extending apparatus as claimed in claims 1 and 3, solving the above-mentioned problems, having such a configuration that is simpler than that of the prior art, and capable of generating a band-extended audio signal having improved frequency characteristic and time characteristic.

According to the first aspect view of the present invention, there is provided an audio signal band extending apparatus. The audio signal band extending apparatus includes noise generating means, signal processing means, and adding means. The noise generating means generates a noise signal level-correlated to and so as to change according to one of a level of an inputted signal and a level of a signal in a partial band obtained by bandpass-filtering the inputted signal using bandpass filtering means. The signal processing means multiplies a generated noise signal by a predetermined transfer function so that, at a lower limit frequency of a predetermined band-extended signal, a level of the generated noise signal substantially coincides with the level of the inputted signal and a spectral continuity thereof is kept when addition is executed by adding means, and outputs a signal having a multiplication result. The adding means adds up the inputted signal and an outputted signal from the signal processing means, and outputs a signal having an addition result.

The above-mentioned audio signal band extending apparatus preferably further includes first conversion means provided so as to be inserted at the previous stage of the bandpass filtering means, for converting the inputted signal into a digital signal, and second conversion means provided so as to be inserted between the signal processing means and the adding means, for converting the outputted signal from the signal processing means into an analog signal.

In addition, the above-mentioned audio signal band extending apparatus preferably further includes oversampling type low-pass filtering means provided so as to be inserted at the previous stage of the bandpass filtering means and the adding means, for oversampling and low-pass filtering the inputted signal, and for outputting a resultant signal to the bandpass filtering means and the adding means.

Further, the above-mentioned audio signal band extending apparatus preferably further includes oversampling type low-pass filtering means provided to be inserted at the previous stage of the adding means, for oversampling and low-pass filtering the inputted signal, and for outputting a resultant signal to the adding means, and oversampling means provided to be inserted between the noise generating means and the signal processing means, for oversampling the noise signal from the noise generating means, and for outputting a resultant signal to the signal processing means.

Still further, in the above-mentioned audio signal band extending apparatus the noise generating means preferably includes level signal generating means, noise signal generating means, and multiplying means. The level signal generating means detects a level of a signal inputted to the noise generating means, and generates and outputs a level signal having a detected level. The noise signal generating means generates and outputs a noise signal according to the signal inputted to the noise generating means. The multiplying means multiplies the level signal from the level signal generating means by the noise signal from the noise signal generating means, and outputs a noise signal having a multiplication result.

In addition, in the above-mentioned audio signal band extending apparatus, the noise signal generating means preferably includes a delta sigma modulator type quantizer, generates a quantized noise signal of a signal inputted to the noise signal generating means, and outputs a generated quantized noise signal as the noise signal.

Further, the above-mentioned audio signal band extending apparatus includes first cutting-out means, at least one second cutting-out means, and multiplying means. The first cutting-out means cuts out predetermined higher-order bits from the signal inputted to the noise generating means, and outputs a signal including the higher-order bits. The at least one second cutting-out means cuts out at least one of predetermined intermediate-order bits and predetermined lower-order bits from the signal inputted to the noise generating means, and outputs a signal including the at least one of the predetermined intermediate-order bits and predetermined lower-order bits. The multiplying means multiplies a signal from the first cutting-out means by a signal from the second cutting-out means, and outputs a noise signal having a multiplication result.

In this case, the second cutting-out means preferably cuts out either one of a combination of intermediate-order bits and lower-order bits, and two lower-order bits, at different bit locations and with a predetermined bit width, adding up cut out bits, and outputs a signal having an addition result. Alternatively, the second cutting-out means preferably cuts out either one of a combination of intermediate-order bits and two lower-order bits, and three lower-order bits, at different bit locations and with a predetermined bit width, adding up cut out bits, and outputs a signal having an addition result. In stead, the above-mentioned audio signal band extending apparatus preferably includes independent noise generating means for generating a noise signal independent of the inputted signal, and further adding means for adding up the noise signal from the second cutting-out means and the noise signal from the independent noise generating means, and for outputting a signal having an addition result to the multiplying means.

In addition, in the above-mentioned audio signal band extending apparatus, the independent noise generating means preferably generates a plurality of noise signals different from each other, adds up the plurality of noise signals, and outputs a signal having an addition result.

Further, in the above-mentioned audio signal band extending apparatus, the independent noise generating means preferably generates a diamond dithering noise signal.

In the above-mentioned audio signal band extending apparatus, the noise generating means preferably includes non-uniformity quantization means, dequantization means, and subtraction means. The non-uniformity quantization means quantizes a signal inputted to the noise generating means non-uniformly relative to a level thereof, and outputs a resultant signal. The dequantization means executes a processing opposite to a processing executed by the non-uniformity quantization means on a signal from the non-uniformity quantization means, and outputs a resultant signal. The subtraction means generates and outputs a quantized noise signal of the signal inputted to the noise generating means by calculating a difference between the signal inputted to the noise generating means and a signal from the dequantization means.

In this case, in the above-mentioned audio signal band extending apparatus, the non-uniformity quantization means preferably quantizes an inputted signal so as to increase a quantization width as a level of the inputted signal is larger.

In addition, in the above-mentioned audio signal band extending apparatus, the non-uniformity quantization means preferably compresses a run length of a linear code of L bits into 1/N thereof so as to generate and output data of M bits, where L, M and N are positive integers each of which equals to or larger than 2.

In the above-mentioned audio signal band extending apparatus, the non-uniformity quantization means preferably converts a linear code of L bits that consists of continuous data Q0 of continuous bits each having a predetermined logic and being allocated in a higher order part, an inverted bit T0 that breaks continuity of the continuous data Q0, and lower-order data D0 following the inverted bit T0, into compressed data of M bits consisting of compressed continuous data Q1 obtained by compressing a run length of the continuous data Q0, an inverted bit T1 for that breaks continuity of the compressed continuous data Q1, compressed residual data F1 representing a residue generated upon compressing the run length, and mantissa data D1 obtained by rounding the lower-order data D0, and outputs the compressed data of M bits. Provided that the run length of the continuous data Q0 is L0, a run length of the compressed continuous data Q1 is L1, and that N is an integer equal to or larger than 2, the run length L1 of the compressed continuous data Q1 and the compressed residual data F1 are expressed by L1 = Int (L0/N) and F1 = L0 mod N, respectively, where Int is a function that represents an integer value of an argument, and A mod B is a function that represents a residue obtained when A is divided by B.

In addition, In the above-mentioned audio signal band extending apparatus, the dequantization means preferably extends a compressed data that consists of compressed continuous data Q1 of continuous bits each having a predetermined logic and being allocated in a higher-order part, an inverted bit T1 that breaks continuity of the compressed continuous data Q1, compressed residual data F1 representing a residue generated upon compressing a run length of the compressed continuous data Q1, and a mantissa data D1, by extending the run length of the compressed continuous data Q1 by "N" times, adding continuous data having a length corresponding to a value of the F1, adding an inverted bit T0 that breaks continuity of Q0, further adding the mantissa data D 1 to a resultant data, reading out the continuous data Q0, the inverted bit T0, and the mantissa data D0, and outputting an extended data. Provided that a run length of the continuous data Q0 is L0, a run length of the compressed continuous data Q1 is L1, a residue obtained from the compressed residual data F1 is F1, and N is an integer equal to or larger than 2, the run length L0 and the mantissa data D0 are expressed by L0 = L1*n+F1 and D0 = D1, respectively, where * is an arithmetic symbol representing multiplication.

Further, in the above-mentioned audio signal band extending apparatus, the non-uniformity quantization means preferably floating-encodes an inputted linear code into a floating code having a predetermined effective bit length, and outputs an encoded signal having the floating code.

In the above-mentioned audio signal band extending apparatus, the noise generating means preferably includes table memory means for storing a relationship between the signal inputted to the noise generating means and a noise signal level-correlated to the signal inputted to the noise generating means so as to change according to a level of the signal inputted to the noise generating means, and conversion means for, responsive to the signal inputted to the noise generating means, reading out and outputting a noise signal corresponding to the signal inputted to the noise generating means from the table memory means.

In the above-mentioned audio signal band extending apparatus, the signal processing means preferably includes at least first filtering means, and filters out frequency bands higher than a frequency band of the inputted signal.

In addition, in the above-mentioned audio signal band extending apparatus, the signal processing means preferably includes at least (1/f) filtering means, and applies a (1/f) reduction characteristic to a higher frequency band spectrum of the signal inputted to the signal processing means.

Further, in the above-mentioned audio signal band extending apparatus, the signal processing means preferably includes at least echo adding processing means, and adds an echo signal to a higher frequency band spectrum of the signal inputted to the signal processing means.

Still further, in the above-mentioned audio signal band extending apparatus, the signal processing means preferably includes at least second filtering means, filters out frequency bands higher than a frequency band of the signal inputted to the signal processing means so as to include frequency bands exceeding a Nyquist frequency.

The method, program and computer readable medium disclosed below are not part of the invention.

According to a second aspect view, there is provided an audio signal band extending method including a noise generating step, a signal processing step, and an adding step. The noise generating step generates a noise signal level-correlated to and so as to change according to one of a level of an inputted signal and a level of a signal in a partial band obtained by bandpass-filtering the inputted signal using a bandpass filtering step. The signal processing step of multiplies a generated noise signal by a predetermined transfer function so that, at a lower limit frequency of a predetermined band-extended signal, a level of the generated noise signal substantially coincides with the level of the inputted signal and a spectral continuity thereof is kept when addition is executed in an adding step, and outputs a signal having a multiplication result. The adding step adds up the inputted signal and an outputted signal from the signal processing step, and outputs a signal having an addition result.

The above-mentioned audio signal band extending preferably further includes a first conversion step inserted and executed prior to the bandpass filtering step, and a second conversion step inserted and executed between the signal processing step and the adding step. The first conversion step converts the inputted signal into a digital signal, and the second conversion step converts the outputted signal from the signal processing step into an analog signal.

In addition, the above-mentioned audio signal band extending method preferably further includes an oversampling type low-pass filtering step inserted and executed prior to the bandpass filtering step and the adding step. The oversampling type low-pass filtering step oversamples and low-pass filters the inputted signal, and outputs a resultant signal to the bandpass filtering step and the adding step.

Further, the above-mentioned audio signal band extending method preferably further includes an oversampling type low-pass filtering step inserted and executed prior to the adding step, and an oversampling means step inserted and executed between the noise generating step and the signal processing step. The oversampling type low-pass filtering step over samples and low-pass filters the inputted signal, and outputs a resultant signal to the adding step. The oversampling means oversamples the noise signal from the noise generating step, and outputs a resultant signal to the signal processing step.

Still further, in the above mentioned audio signal band extending method, the noise generating step preferably includes a level signal generating step, a noise signal generating step, and a multiplying step. The level signal generating step detects a level of a signal inputted to the noise generating step, and generates and outputs a level signal having a detected level. The noise signal generating step generates and outputs a noise signal according to the signal inputted to the noise generating step. The multiplying step multiplies the level signal from the level signal generating step by the noise signal from the noise signal generating step, and outputs a noise signal having a multiplication result.

In addition, in the above-mentioned audio signal band extending method the noise signal generating step preferably includes a delta sigma modulator type quantizer step, generates a quantized noise signal of a signal inputted to the noise signal generating step, and outputs a generated quantized noise signal as the noise signal.

Further, in the above-mentioned audio signal band extending method the noise generating step preferably includes a first cutting-out step, at least one second cutting-out step, and a multiplying step. The first cutting-out cuts out predetermined higher-order bits from the signal inputted to the noise generating step, and outputs a signal including the higher-order bits. The at least one second cutting-out step of cuts at least one of predetermined intermediate-order bits and predetermined lower-order bits from the signal inputted to the noise generating step, and outputs a signal including the at least one of the predetermined intermediate-order bits and predetermined lower-order bits. The multiplying step multiplies a signal from the first cutting-out step by a signal from the second cutting-out step, and outputs a noise signal having a multiplication result.

In this case, in the above-mentioned audio signal band extending method, the second cutting-out step preferably cuts out either one of a combination of intermediate-order bits and lower-order bits, and two lower-order bits, at different bit locations and with a predetermined bit width, adding up cut out bits, and outputs a signal having an addition result. Alternatively, the second cutting-out step preferably cuts out either one of a combination of intermediate-order bits and two lower-order bits, and three : lower-order bits, at different bit locations and with a predetermined bit width, adding up cut out bits, and outputs a signal having an addition result. In stead, the above-mentioned audio signal band extending method preferably further includes an independent noise generating step of generating a noise signal independent of the inputted signal, and a further adding step of adding up the noise signal from the second cutting-out step and the noise signal from the independent noise generating step, and of outputting a signal having an addition result to the multiplying step.

In addition, in the above-mentioned audio signal band extending method the independent noise generating step preferably generates a plurality of noise signals different from each other, adds up the plurality of noise signals, and outputs a signal having an addition result.

Further, in the above-mentioned audio signal band extending method, the independent noise generating step preferably generates a diamond dithering noise signal.

In the above-mentioned audio signal band extending method, the noise generating step preferably includes a non-uniformity quantization step, a dequantization step, and a subtraction step. The non-uniformity quantization step quantizes a signal inputted to the noise generating step non-uniformly relative to a level thereof, and outputs a resultant signal. The dequantization step executes a processing opposite to a processing executed by the non-uniformity quantization step on a signal from the non-uniformity quantization step, and outputs a resultant signal. The subtraction step generates and outputs a quantized noise signal of the signal inputted to the noise generating step by calculating a difference between the signal inputted to the noise generating step and a signal from the dequantization step.

In the above-mentioned audio signal band extending, the non-uniformity quantization step preferably quantizes an inputted signal so as to increase a quantization width as a level of the inputted signal is larger.

In addition, in the above-mentioned audio signal band extending method the non-uniformity quantization step preferably compresses a run length of a linear code of L bits into $1/N$ thereof so as to generate and output data of M bits, where L, M and N are positive integers each of which equals to or larger than 2.

In the above-mentioned audio signal band extending, the non-uniformity quantization step preferably converts a linear code of L bits that consists of continuous data Q0 of continuous bits each having a predetermined logic and being allocated in a higher order part, an inverted bit T0 that breaks continuity of the continuous data Q0, and lower-order data D0 following the inverted bit T0, into compressed data of M bits consisting of compressed continuous data Q1 obtained by compressing a run length of the continuous data Q0, an inverted bit T1 for that breaks continuity of the compressed continuous data Q1, compressed residual data F1 representing a residue generated upon compressing the run length, and mantissa data D 1 obtained by rounding the lower-order data D0, and outputs the compressed data of M bits. Provided that the run length of the continuous data Q0 is L0, a run length of the compressed continuous data Q1 is L1, and that N is an integer equal to or larger than 2, the run length L1 of the compressed continuous data Q1 and the compressed residual data F1 are expressed by $L1 = Int (L0/N)$ and $F1 = L0 \bmod N$, respectively, where Int is a function that represents an integer value of an argument, and A mod B is a function that represents a residue obtained when A is divided by B.

In addition, in the above-mentioned audio signal band extending method, the dequantization step preferably extends a compressed data that consists of compressed continuous data Q1 of continuous bits each having a predetermined logic and being allocated in a higher-order part, an inverted bit T1 that breaks continuity of the compressed continuous data Q1, compressed residual data F1 representing a residue generated upon compressing a run length of the compressed continuous data Q1, and a mantissa data D1, by extending the run length of the compressed continuous data Q1 by "N" times, adding continuous data having a length corresponding to a value of the F1, adding an inverted bit T0 that breaks continuity of Q0, further adding the mantissa data D 1 to a resultant data, reading out the continuous data Q0, the inverted bit T0, and the mantissa data D0, and outputting an extended data. Provided that a run length of the continuous data Q0 is L0, a run length of the compressed continuous data Q1 is L1, a residue obtained from the compressed residual data F1 is F1, and N is an integer equal to or larger than 2, the run length L0 and the mantissa data D0 are expressed by L0 = L1*n+F1 and D0 = D1, respectively, where * is an arithmetic symbol representing multiplication.

Further, in the above-mentioned audio signal band extending method, the non-uniformity quantization step preferably floating-encodes an inputted linear code into a floating code having a predetermined effective bit length, and outputs an encoded signal having the floating code.

In the above-mentioned audio signal band extending method, the noise generating step preferably includes a table memory step and a conversion step. The table memory step stores a relationship between the signal inputted to the noise generating step and a noise signal level-correlated to the signal inputted to the noise generating step so as to change according to a level of the signal inputted to the noise generating step. The conversion step, responsive to the signal inputted to the noise generating step, reads out and outputs a noise signal corresponding to the signal inputted to the noise generating step from the table memory step.

In the above-mentioned audio signal band extending, the signal processing step preferably includes at least a first filter step, and filters out frequency bands higher than a frequency band of the inputted signal.

In addition, in the above-mentioned audio signal band extending method, the signal processing step preferably includes at least a (1/f) filtering step, and applies a (1/f) reduction characteristic to a higher frequency band spectrum of the signal inputted to the signal processing step.

Further, in the above-mentioned audio signal band extending method, the signal processing step preferably includes at least an echo adding processing step, and adds an echo signal to a higher frequency band spectrum of the signal inputted to the signal processing step.

Still further, in the above-mentioned audio signal band extending method the signal processing step preferably includes at least a second filtering step, and filters out frequency bands higher than a frequency band of the signal inputted to the signal processing step so as to include frequency bands exceeding a Nyquist frequency.

According to a third aspect view, there is provided an optical disk system including a reproduction apparatus for reproducing an audio signal stored in an optical disk, and the above-mentioned audio signal band extending apparatus for extending a band of a reproduced audio signal, and for outputting a band-extended audio signal.

According to a fourth aspect view, there is provided a program that includes the respective steps of the above-mentioned audio signal band extension method.

According to a fifth aspect view, there is provided a computer readable recording medium that stores a program including the respective steps of the above-mentioned audio signal band extension method.

Therefore, according to the audio signal band extending apparatus according to the present invention, there is generated a noise signal having a level changing according to a level of an inputted signal and correlated to the level of the inputted signal in bands equal to or higher than the band of the inputted signal, and the noise signal is added to the inputted signal so as to keep the spectral continuity thereof. Accordingly, it is possible to easily generate a signal having an extended audio band as compared with the prior art. In addition, a band-extended signal obtained as stated above changes according to a level of an original sound and keeps its spectral continuity. Accordingly, the apparatus according to the present invention exhibits such an advantageous effect that a higher frequency component of the band-extended signal sounds not artificial but natural relative to the original sound.

In addition, according to the audio signal band extending apparatus according to the present invention, the bandpass filtering processing, the level correlated white noise generating processing, and the signal processing are executed by digital signal processing. Accordingly, variations in performance do not occur due to variations in components that constitute circuits, and temperature characteristic. In addition, deterioration in sound quality does not occur when the audio signal passes through each of the circuits. Further, even if the accuracy of each filter that constitutes the same circuit is improved, size of circuits is not made large and manufacturing cost is not increased, in a manner different from that of an apparatus constituted by analog circuits.

Further, according to the audio signal band extending apparatus according to the present invention, before the bandpass filtering processing and the final adding processing are executed, the oversampling processing and a low-pass filtering processing are executed. Accordingly, the lower-order analog low-pass filter can be provided at the previous stage of the A/D converter, and this leads to extremely large reduction in the phase distortion and then noise accompanied by the filtering processing. In addition, the quantized noise can be reduced, and_conversion at a low quantization bit rate can be easily performed. Further, a higher-order higher harmonic wave component of the inputted signal X can be generated in advance and used, and therefore a higher-order higher harmonic wave component can be easily generated.

Still further, according to the audio signal band extending apparatus according to the present invention, the oversampling processing is inserted between the level correlated white noise generating processing and the signal processing, and executed. In addition, before the final adding processing is executed, the oversampling processing and the low-pass filtering processing are executed on the inputted signal. Accordingly, it is possible to set a signal rate to a higher signal rate in the circuits provided at the subsequent stage of the oversampling type low-pass filter and the oversampling circuit. In other words, it is possible to set signal rates of circuits provided at the previous stage of the oversampling type low-pass filter and the oversampling circuit to lower signal rates, and this leads to simplification of the circuit configuration.

In addition, the optical disk system can reproduce an audio signal stored in an optical disk, extends a band of a reproduced audio signal, and output a band-extended audio signal. Accordingly, it is possible to easily generate a signal having an extended audio band based on the audio signal stored in the optical disk as compared with the prior.

BRIEF DESCRIPTION OF DRAWINGS

Fig. 1 is a block diagram showing a configuration of an audio signal band extending apparatus 100-1 according to a first preferred embodiment of the present invention.

Fig. 2 is a block diagram showing a configuration of an audio signal band extending apparatus 100-2 according to a second preferred embodiment of the present invention.

Fig. 3 is a block diagram showing a configuration of an audio signal band extending apparatus 100-3 according to a third preferred embodiment of the present invention.

Fig. 4 is a block diagram showing a configuration of an audio signal band extending apparatus 100-4 according to a fourth preferred embodiment of the present invention.

Fig. 5 is a block diagram showing a configuration of an oversampling type low-pass filter (LPF) 120 shown in Figs. 3 and 4.

Fig. 6 is a signal waveform view showing an operation of an oversampling circuit 11 shown in Fig. 5.

Fig. 7 is a block diagram showing a configuration of a level correlated white noise generator circuit 300-1 according to a first implemental example of a level correlated white noise generator circuit 300 shown in Figs. 1 to 4.

Fig. 8 is a block diagram showing a configuration of a white noise signal generator circuit 320 shown in Fig. 7.

Fig. 9 is a block diagram showing a configuration of a level correlated white noise generator circuit 300-2 according to a second implemental example of the level correlated white noise generator circuit 300 shown in Figs. 1 to 4.

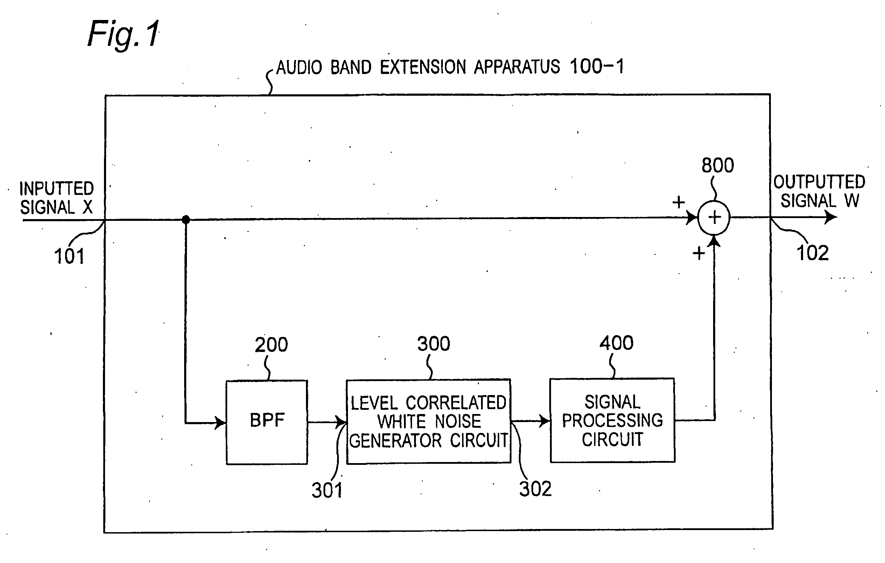

Fig, 10 is a block diagram showing a configuration of a level correlated white noise generator circuit 300-3 according to a third implemental example of the level correlated white noise generator circuit 300 shown in Figs. 1 to 4.

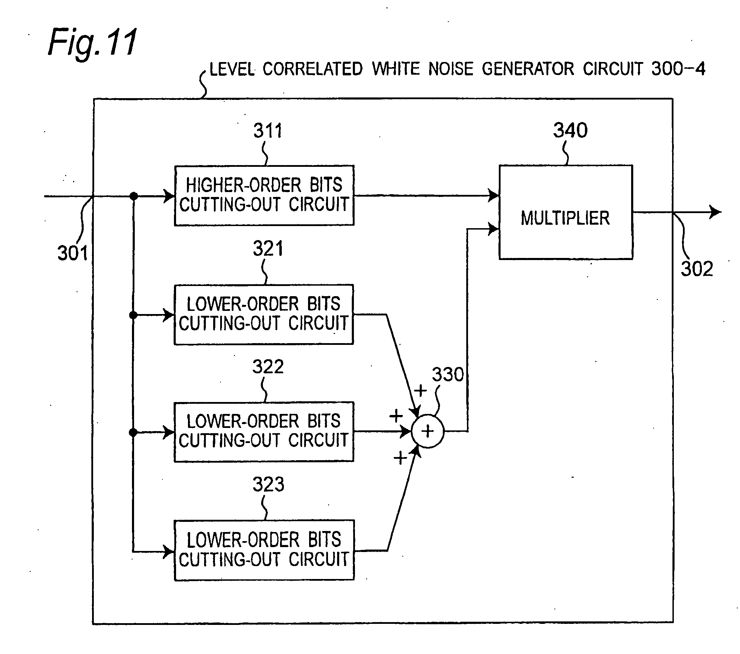

Fig. 11 is a block diagram showing a configuration of a level correlated white noise generator circuit 300-4 according to a fourth implemental example of the level correlated white noise generator circuit 300 shown in Figs. 1 to 4.

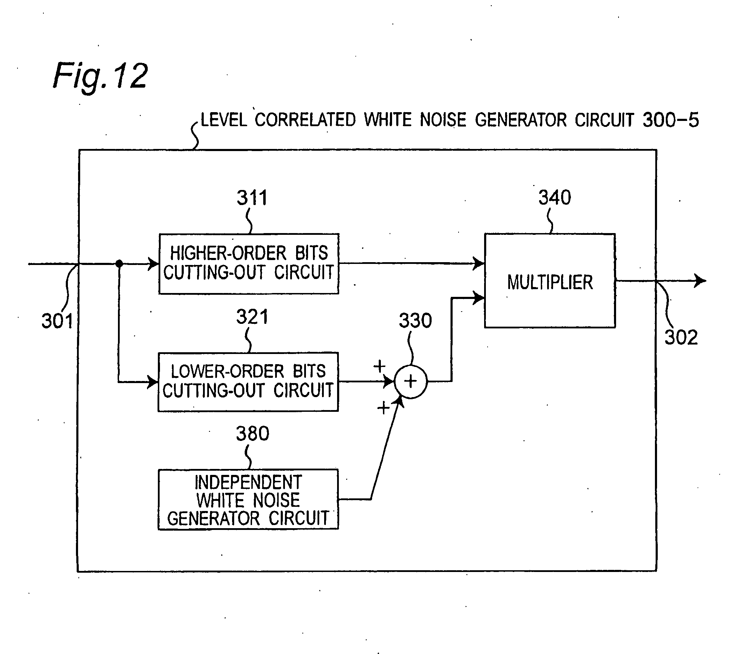

Fig. 12 is a block diagram showing a configuration of a level correlated white noise generator circuit 300-5 according to a fifth implemental example of the level correlated white noise generator circuit 300 shown in Figs. 1 to 4.

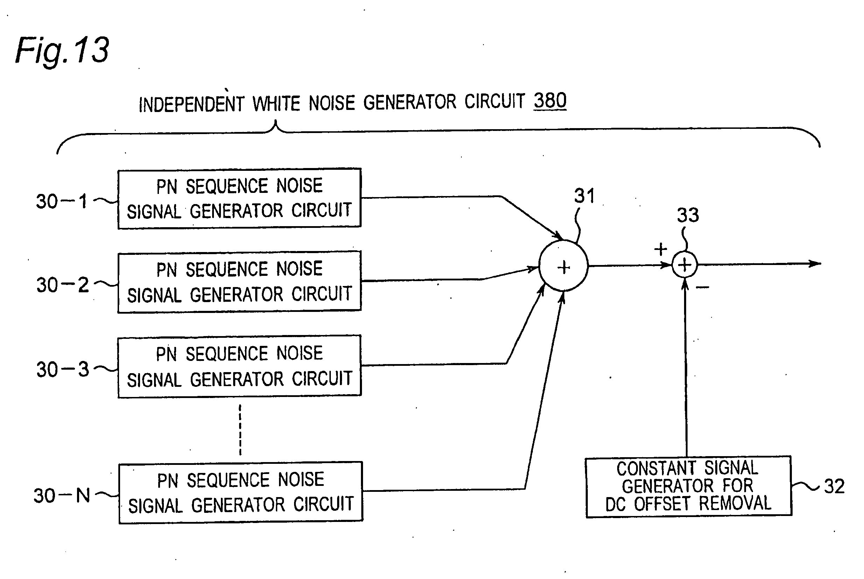

Fig. 13 is a block diagram showing a configuration of an independent white noise generator circuit 380 shown in Fig. 11.

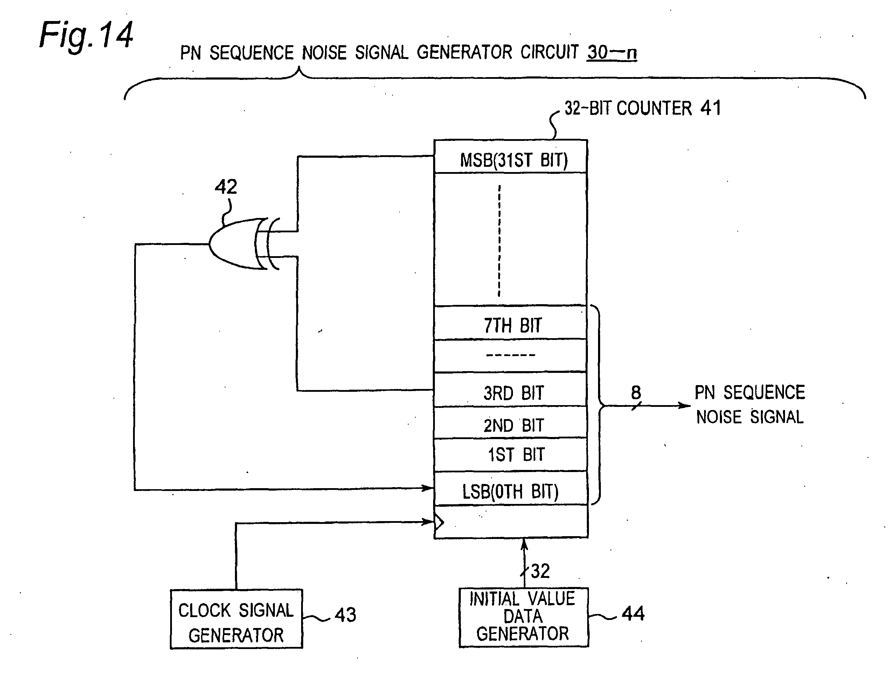

Fig. 14 is a block diagram showing a configuration of a PN sequence noise signal generator circuit 30-n (n = 1, 2, ..., N) shown in Fig. 13.

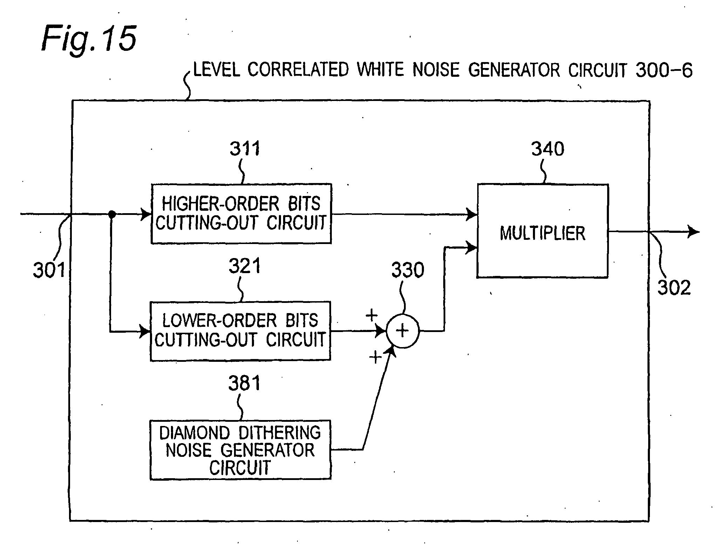

Fig. 15 is a block diagram showing a configuration of a level correlated white noise generator circuit 300-6 according to a sixth implemental example of the level correlated white noise generator circuit 300 shown in Figs. 1 to 4.

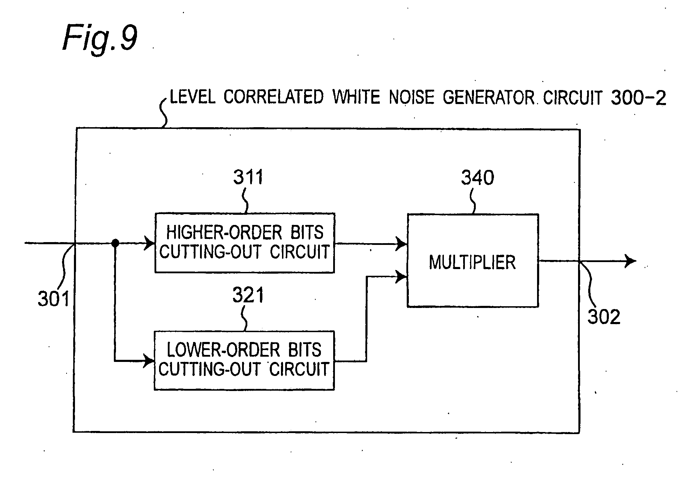

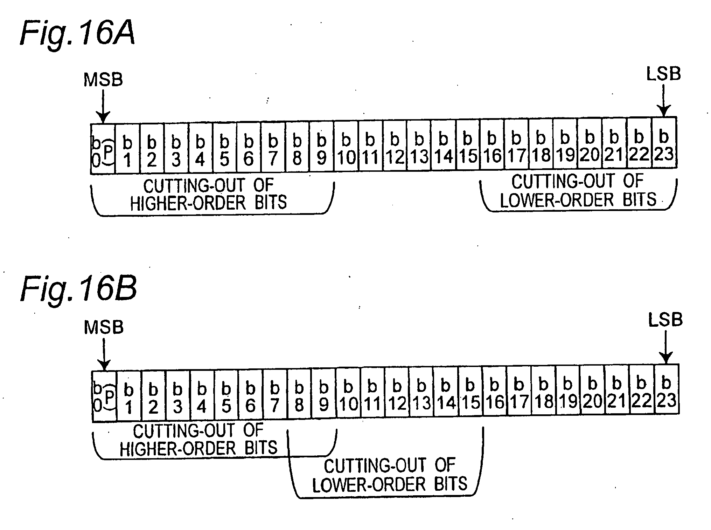

Fig. 16A is a bit arrangement view showing locations of bits to be cut out for the level correlated white noise generator circuits 300-2, 300-5, and 300-6 shown in Fig. 9.

Fig. 16B is a bit arrangement view showing a modified example of locations of bits to be cut out for the level correlated white noise generator circuits 300-2, 300-5, and 300-6 shown in Fig. 9.

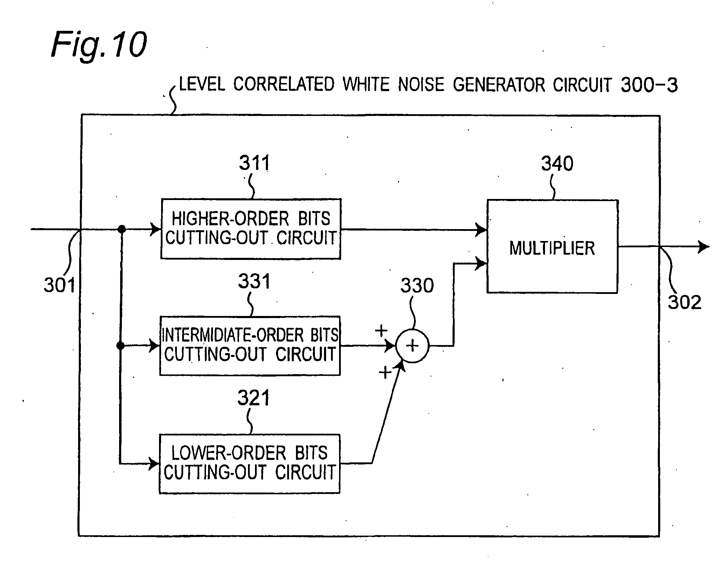

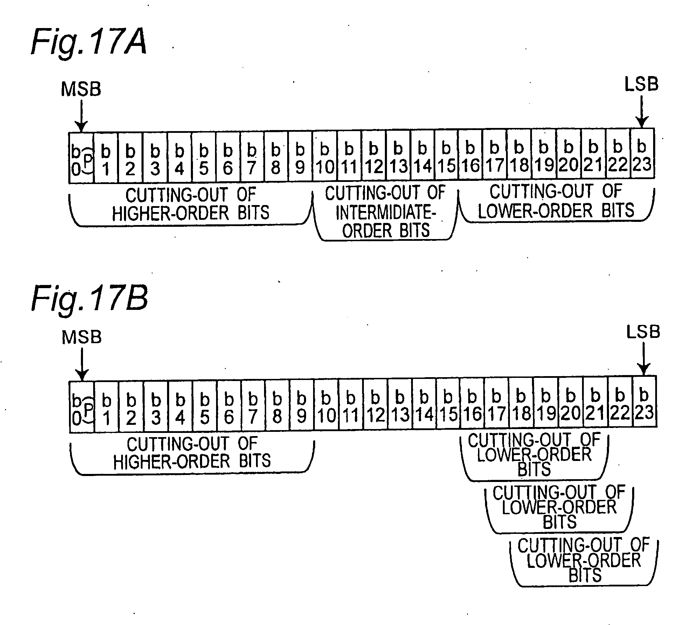

Fig. 17A is a bit arrangement view showing locations of bits to be cut out for the level correlated white noise generator circuit 300-3 shown in Fig. 10.

Fig. 17B is a bit arrangement view showing locations of bits to be cut out for the level correlated white noise generator circuit 300-4 shown in Fig. 11.

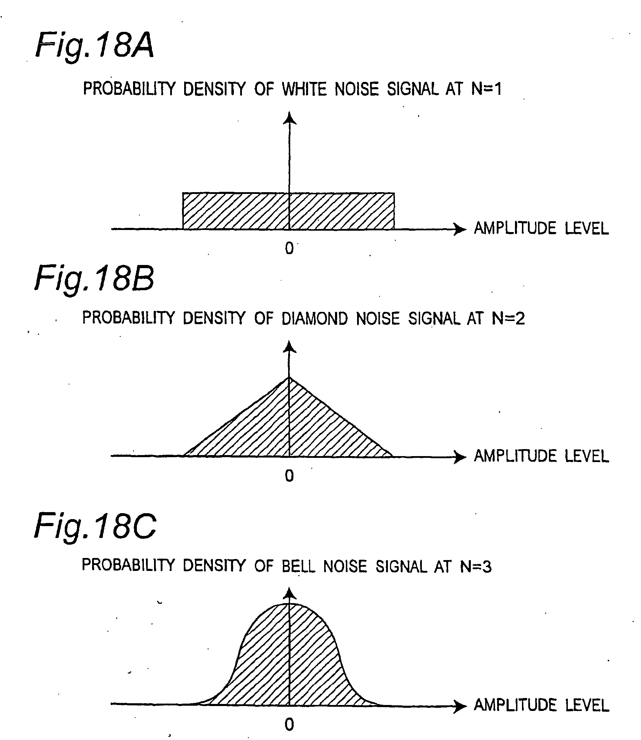

Fig. 18A is a graph showing a function of a probability density relative to an amplitude level of a white noise signal generated by the independent white noise generator circuit 380 shown in Fig. 13 atN = 1.

Fig. 18B is a graph showing a function of a probability density relative to an amplitude level of a diamond noise signal generated by the independent white noise generator circuit 380 shown in Fig. 13 at N = 2.

Fig. 18C is a graph showing a function of a probability density relative to an amplitude level of a bell noise signal generated by the independent white noise generator circuit 380 shown in Fig. 13 at N = 3.

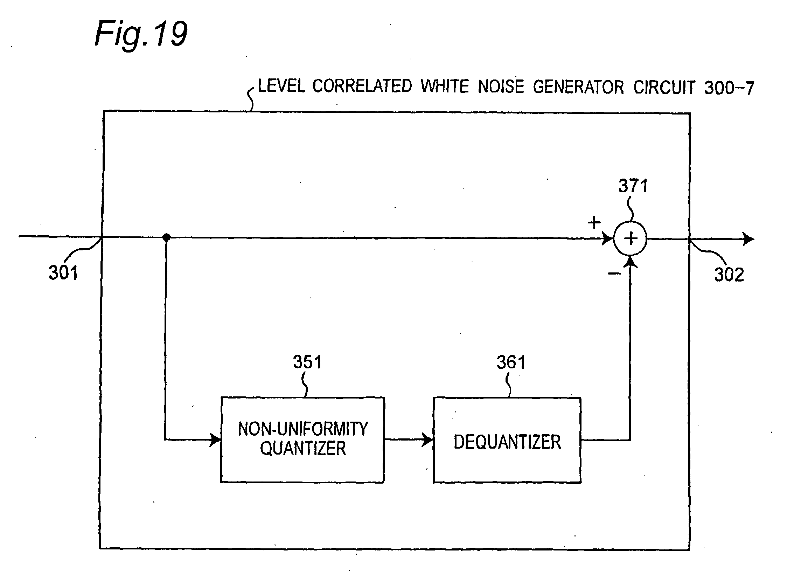

Fig. 19 is a block diagram showing a configuration of a level correlated white noise generator circuit 300-7 according to a seventh implemental example of the level correlated white noise generator circuit 300 shown in Figs. 1 to 4.

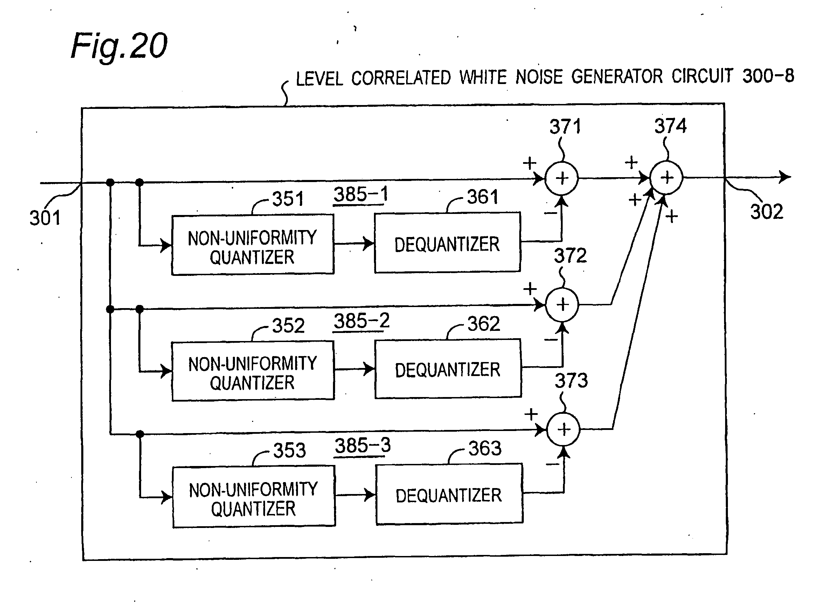

Fig. 20 is a block diagram showing a configuration of a level correlated white noise generator circuit 300-8 according to an eighth implemental example of the level correlated white noise generator circuit 300 shown in Figs. 1 to 4.

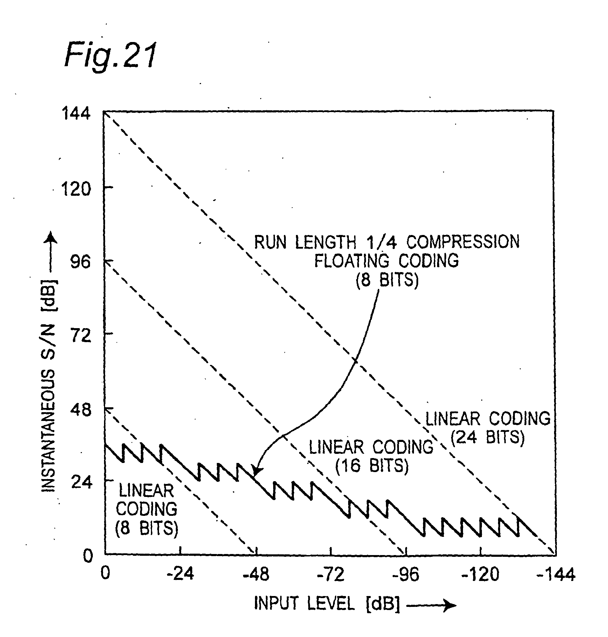

Fig. 21 is a graph showing an instantaneous signal to noise ratio (an instantaneous S/N) relative to an input level for run length 1/4 compression floating coding by a non-uniformity quantizer 351, 352 or 353 shown in Figs. 19 and 20 and that for linear coding of 8 bits, 16 bits or 24 bits.

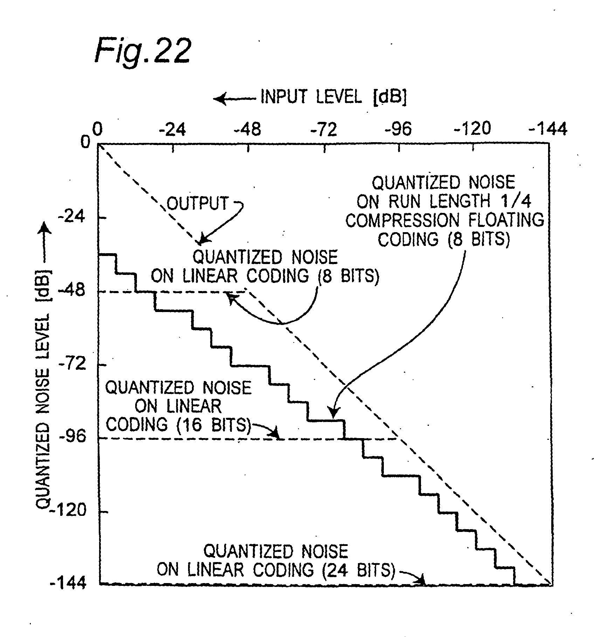

Fig. 22 is a graph showing a quantized noise level relative to an input level for the run length 1/4 compression floating coding by a non-uniformity quantizer 351, 352 or 353 shown in Figs. 19 and 20 and that for linear coding of 8 bits, 16 bits or 24 bits.

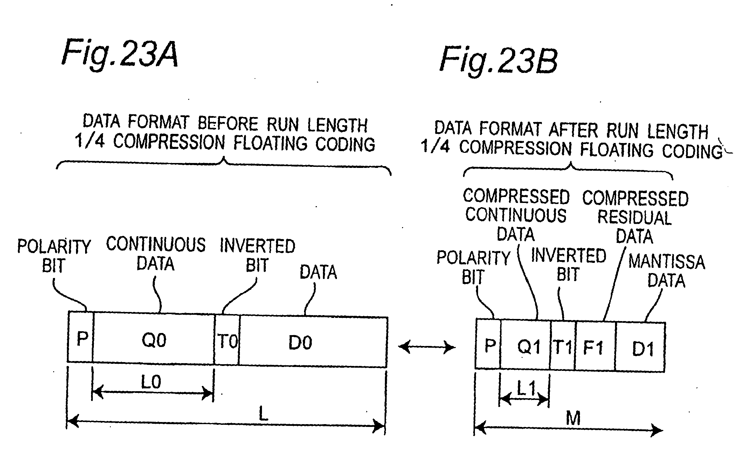

Fig. 23A is a diagram showing a data format before the run length 1/4 compression floating coding by the non-uniformity quantizer 351, 352 or 353 shown in Figs. 19 and 20.

Fig. 23B is a diagram showing depicts a data format after the run length 1/4 compression floating coding by the non-uniformity quantizer 351, 352 or 353 shown in Figs. 19 and 20.

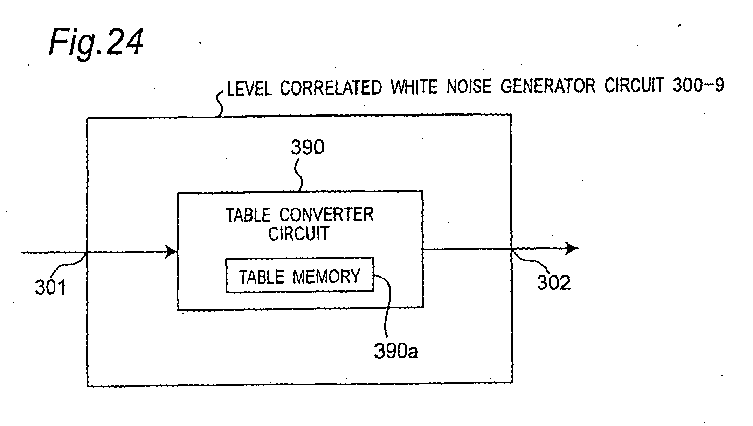

Fig. 24 is a block diagram showing a configuration of a level correlated white noise generator circuit 300-9 according to a ninth implemental example of the level correlated white noise generator circuit 300 shown in Figs. 1 to 4.

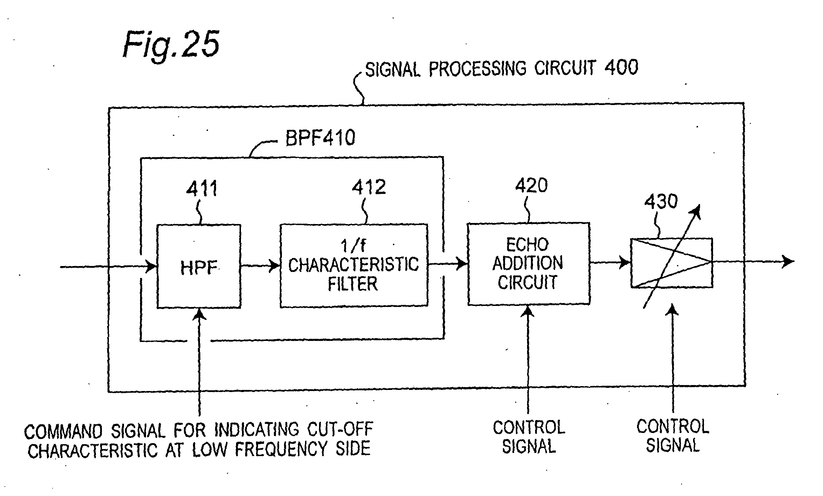

Fig. 25 is a block diagram showing a configuration of a signal processing circuit 400 shown in Figs. 1 to 4.

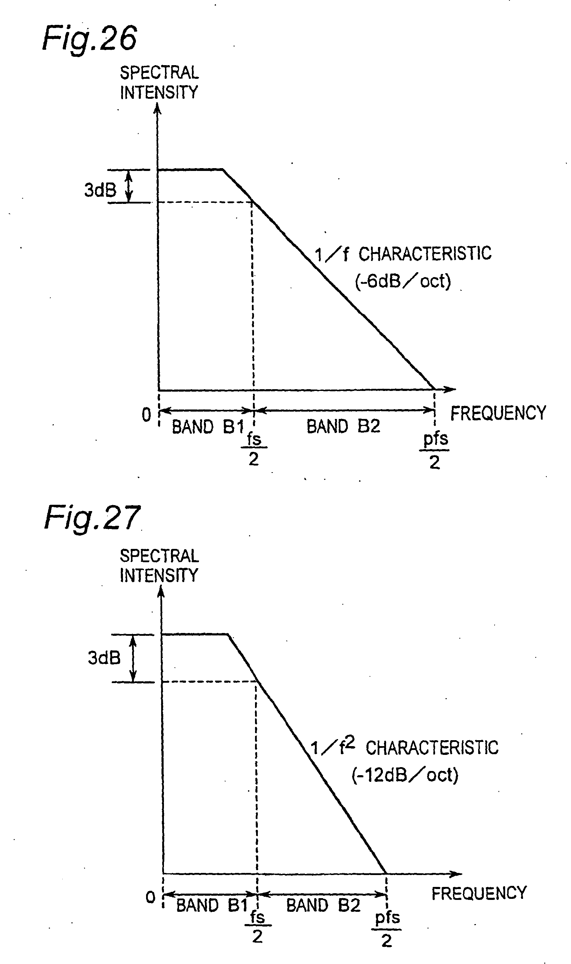

Fig. 26 is a graph showing a frequency characteristic of a (1/f) characteristic of a (1/f) characteristic filter 412 shown in Fig. 25.

Fig. 27 is a graph showing a frequency characteristic a $(1/f^2)$ characteristic of a modified example of the (1/f) characteristic filter 412 shown in Fig. 25.

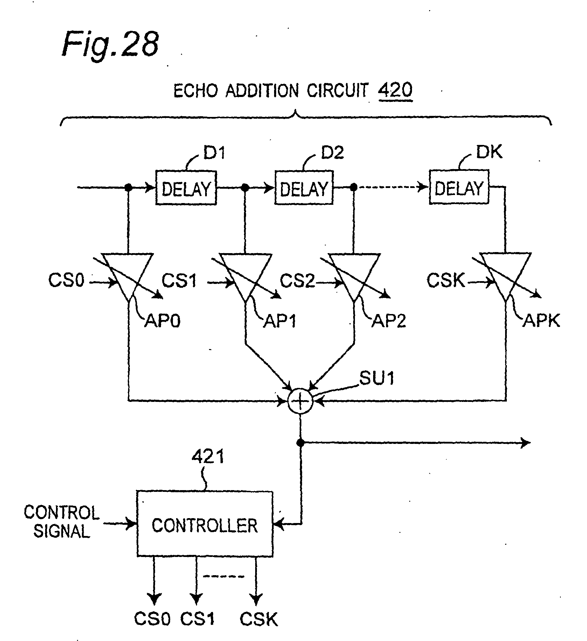

Fig. 28 is a block diagram showing a configuration of a transversal filter that is one implemental example of an echo addition circuit 480 shown in Fig. 25.

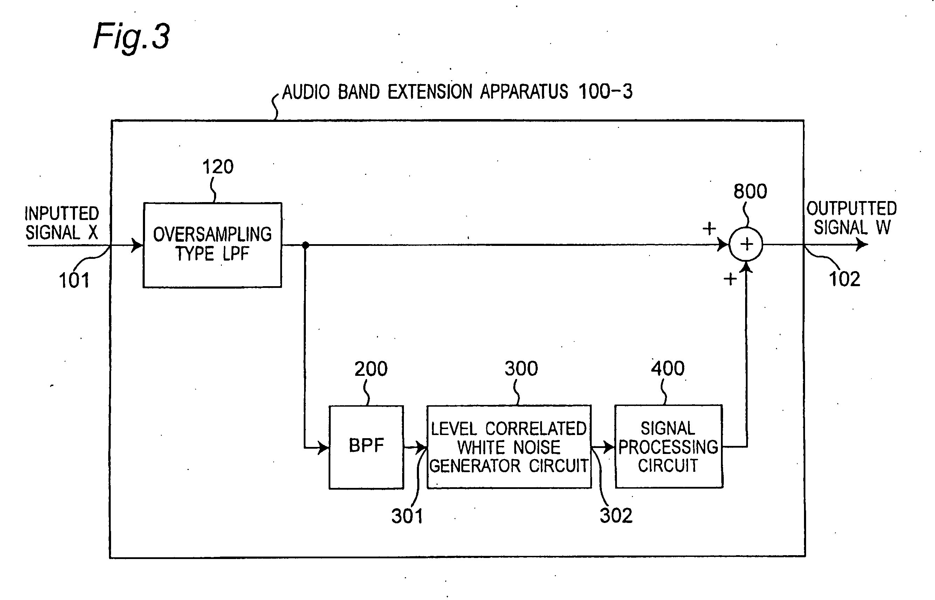

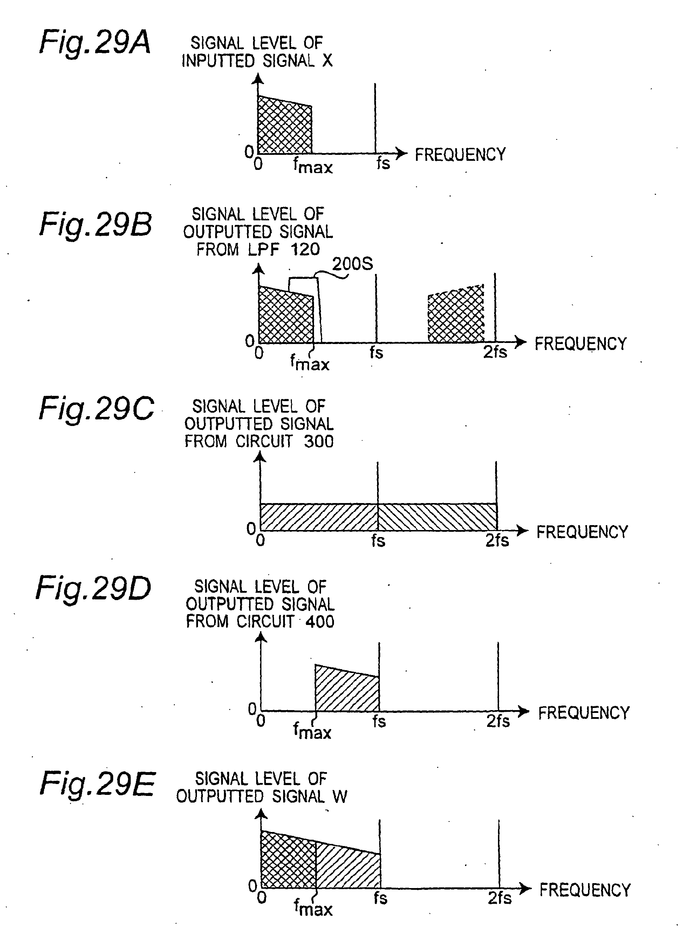

Fig. 29A is a frequency spectral view of an inputted signal X in an operation of the audio signal band extending apparatus 100-3 according to the third preferred embodiment shown in Fig. 3 (at p = 2, that is a twofold oversampling).

Fig. 29B is a frequency spectral view of an outputted signal from an LPF 120 in the same operation as that shown in Fig. 29A.

Fig. 29C is a frequency spectral view of an outputted signal from a circuit 300 in the same operation as that shown in Fig. 29A.

Fig. 29D is a frequency spectral view of an outputted signal from a circuit 400 in the same operation as that shown in Fig. 29A.

Fig. 29E is a frequency spectral view of an outputted signal W in the same operation as that shown in Fig. 29A.

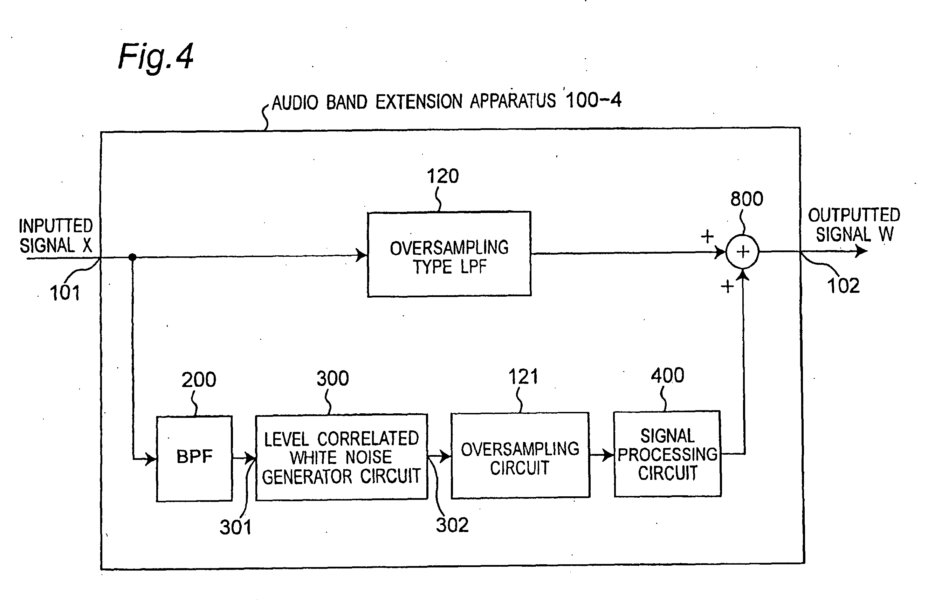

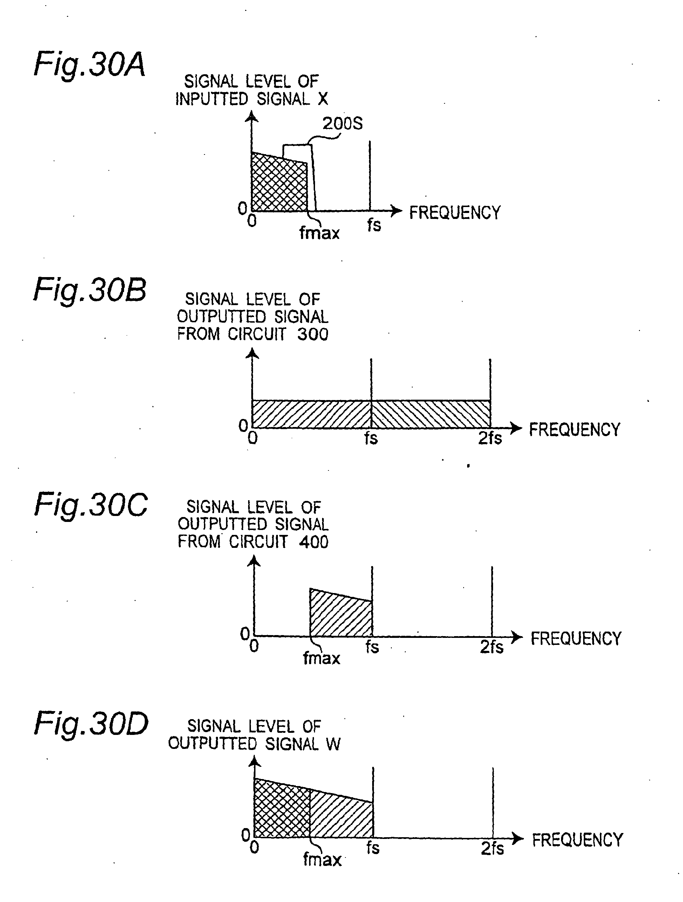

Fig. 30A is a frequency spectral view of an inputted signal X in an operation of the audio signal band extending apparatus 100-4 according to the fourth preferred embodiment shown in Fig. 4 (at p = 2, that is a twofold oversampling).

Fig. 30B is a frequency spectral view of an outputted signal from a circuit 300 in the same operation as that shown in Fig. 30A.

Fig. 30C is a frequency spectral view of an outputted signal from a circuit 400 in the same operation as that shown in Fig. 30A.

Fig. 30D is a frequency spectral view of an outputted signal W in the same operation as that shown in Fig. 30A.

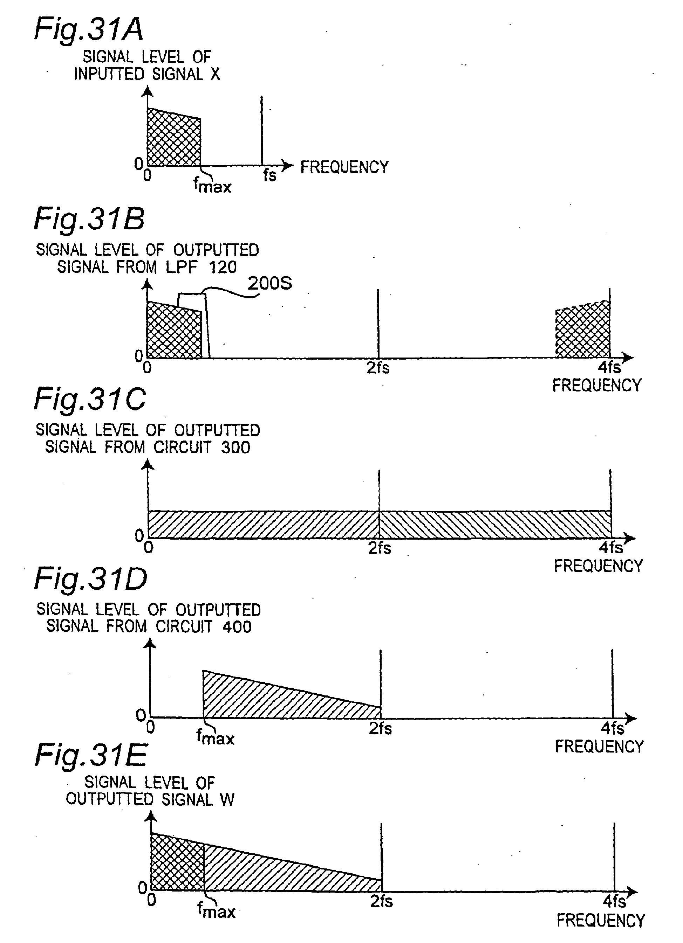

Fig. 31A is a frequency spectral view of an inputted signal X in an operation of the audio signal band extending apparatus 100-3 according to the third preferred embodiment shown in Fig. 3 (at p = 4, that is a fourfold oversampling).

Fig. 31B is a frequency spectral view of the outputted signal from the LPF 120 in the same operation as that shown in Fig. 31A.

Fig. 31C is a frequency spectral view of the outputted signal from the circuit 300 in the same operation as that shown in Fig. 31A.

Fig. 31D is a frequency spectral view of the outputted signal from the circuit 400 in the same operation as that shown in Fig. 31A.

Fig. 31E is a frequency spectral view of the outputted signal W in the same operation as that shown in Fig. 31A.

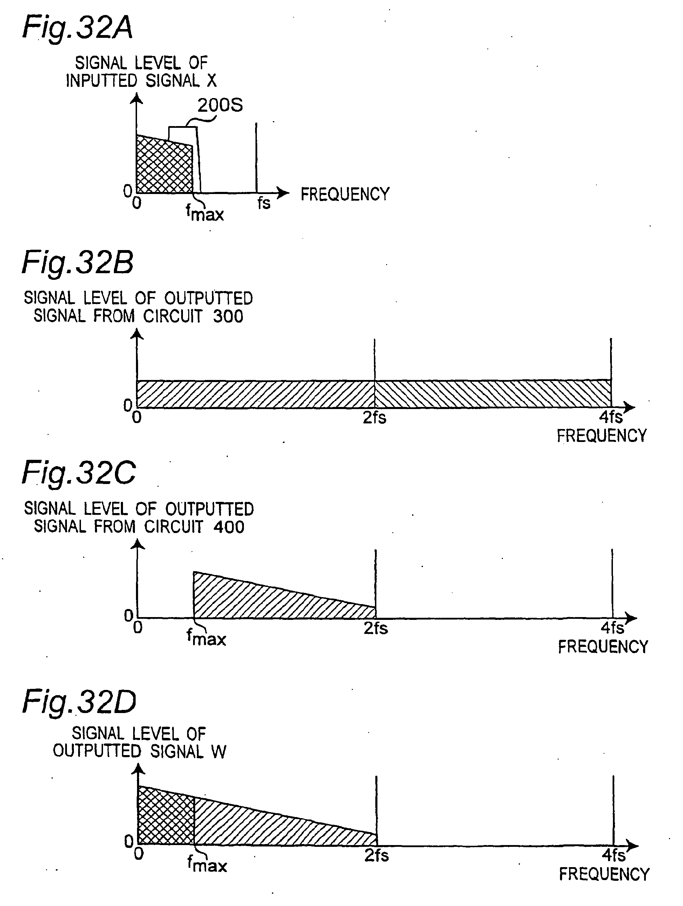

Fig. 32A is a frequency spectral view of an inputted signal X in an operation of the audio signal band extending apparatus 100-4 according to the fourth preferred embodiment shown in Fig. 4 (at p = 4, that is a fourfold oversampling).

Fig. 32B is a frequency spectral view of the outputted signal from a circuit 300 in the same operation as that shown in Fig. 32A.

Fig. 32C is a frequency spectral view of the outputted signal from a circuit 400 in the same operation as that shown in Fig. 32A.

Fig. 32D is a frequency spectral view of the outputted signal W in the same operation as that shown in Fig. 32A.

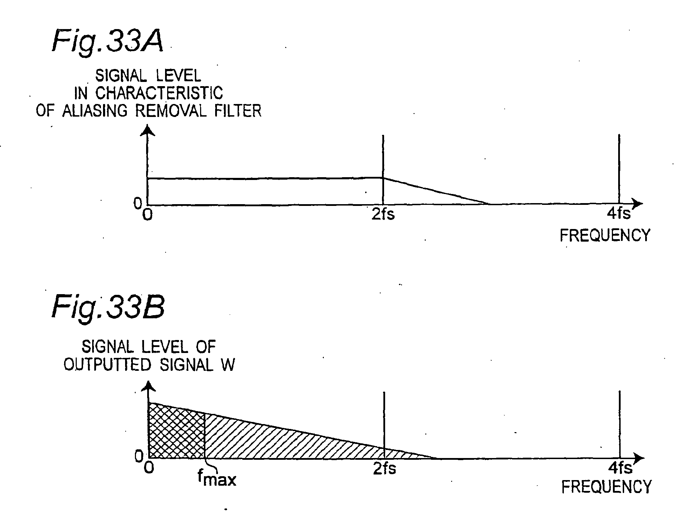

Fig. 33A is a frequency spectral view showing a characteristic of an aliasing removal filter instead of the (1/f) characteristic filter 412 that is a modified example of Figs. 31A to 31E and Figs. 32A to 32D.

Fig. 33B is a frequency spectral view of an outputted signal W from the aliasing removal filter shown in Fig. 33A.

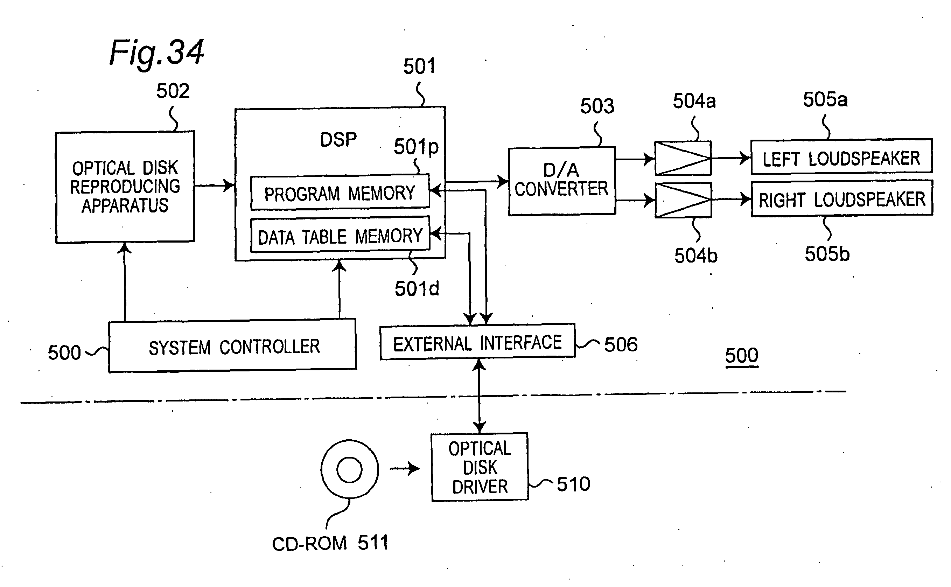

Fig. 34 is a block diagram showing a configuration of an optical disk reproduction system 500, which is one example of an application of the audio signal band extending apparatus, according to a fifth preferred embodiment of the present invention.

## BEST MODE FOR CARRYING OUT THE INVENTION

Preferred embodiments according the present invention will be described below with reference to the drawings. In the attached drawings, components similar to each other are denoted by the same numerical references, respectively, and will not be repeatedly described in detail.

## FIRST PREFERRED EMBODIMENT

Fig. 1 is a block diagram showing a configuration of an audio signal band extending apparatus 100-1 according to a first preferred embodiment of the present invention. As shown in Fig. 1, the audio signal band extending apparatus 100-1 according to the first preferred embodiment is an analog signal processing circuit that is inserted between an input terminal 101 and an output terminal 102, and constructed by including a bandpass filter (BPF) 200, a level correlated white noise generator circuit 300, a signal processing circuit 400, and an adder 800.

Referring to Fig. 1, an analog audio signal (referred to as an inputted signal hereinafter) X is inputted to the bandpass filter 200 and the adder 800 via the input terminal 101. The inputted signal X is such a signal that is reproduced from a compact disk (CD) or such a signal that has, for example, a band from 20 Hz to 20 kHz. The bandpass filter 200 bandpass-filters the inputted signal X to pass therethrough a part of a band (referred to as a partial band hereinafter, which is a higher band of the inputted signal from, for example, 10 kHz to 20 kHz or from 5 kHz to 15 kHz in another example) of the inputted signal X, and outputs a resultant signal to the level correlated white noise generator circuit 300. Next, the level correlated white noise generator circuit 300 generates a white noise signal having a level changing according to a level of an audio signal in the partial band inputted via an input terminal 301 thereof, that is, having a level-correlated level, and outputs the white noise signal to the signal processing circuit 400 via an output terminal 302 thereof. Further, the signal processing circuit 400 executes such a signal processing that includes predetermined bandpass filtering processing, echo adding processing, and level adjusting processing on an inputted white noise signal, so to speak a processing for multiplying the inputted white noise signal by a predetermined transfer function, and thereafter outputs a processed white noise signal to the adder 800. Finally, the adder 800 adds the white noise signal from the signal processing circuit 400 to the inputted signal X, and outputs a band-extended signal having an addition result, as an outputted signal W.

The processings executed by the signal processing circuit 400 will be described later in detail with reference to Fig. 25. In this case, preferably, a lower limit frequency of a passing band for the bandpass filtering processing executed by the signal processing circuit 400 is substantially the same as a maximum frequency of the inputted signal X so that levels of two signals on which the addition processing is executed by the adder 800 substantially coincide with each other at the lower limit frequency, and so that the spectral continuity thereof can be kept. In addition, a higher limit frequency of the passing band for the bandpass filtering processing executed by the signal processing circuit 400 is preferably set to be equal to or higher than a twofold or fourfold of the maximum frequency of the inputted signal X. Further, when the bandpass filter 200 has such a bandpass characteristic that an upper limit frequency of the bandpass filter 200 is the same as a Nyquist frequency, for example, when the bandpass filter 200 has a passing band from 10 kHz to 20 kHz, the bandpass filter 200 may be replaced by a high-pass filter for passing therethrough a signal at a frequency equal to or higher than 10 kHz.

The audio signal band extending apparatus 100-1 configured as stated above does not need any level detections and easily generates an audio signal having an extended audio band. In addition, an obtained band-extended signal has a level changing according to a level of an original sound of the inputted signal X, correlates with the level of the original sound of the inputted signal X, changes according to the level of the original sound of the inputted signal X, and keeps its spectral continuity. Accordingly, the audio signal band extending apparatus 100-1 method exhibits such an advantageous effect that a higher frequency component of the band-extended signal sounds not artificial but natural relative to the original sound.

In the above-stated preferred embodiment, the audio signal band extending apparatus 100-1 includes the bandpass filter 200. However, the present invention is not limited to this, and the apparatus 100-1 does not necessarily include the bandpass filter 200. In this case, the level correlated white noise generator circuit 300 generates a white noise signal level-correlated so that a level of the level-correlated noise signal changes according to that of the inputted signal X.

## SECOND PREFERRED EMBODIMENT

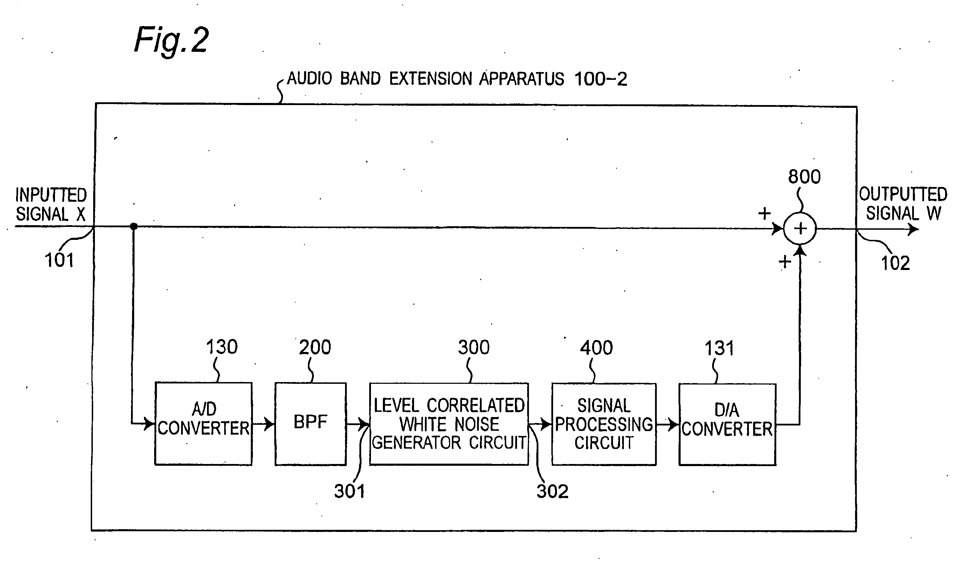

Fig. 2 is a block diagram showing a configuration of an audio signal band extending apparatus 100-2 according to a second preferred embodiment of the present invention. The audio signal band extending apparatus 100-2 according to the second preferred embodiment is characterized, as compared with the audio signal band extending apparatus 100-1 shown in Fig. 1, by inserting an A/D converter 130 at the previous stage of a bandpass filter 200 and inserting a D/A converter 131 at the subsequent stage of the signal processing circuit 400 so that the respective processings of the bandpass filter (BPF) 200, the level correlated white noise generator circuit 300, and the signal processing circuit 400 are executed as digital signal processings instead of analog signal processing. Differences between the present preferred embodiment and the first preferred embodiment will be described in detail hereinafter.

Referring to Fig. 2, the inputted signal X is converted into a signal which has, for example, a sampling frequency fs of 44.1 kHz and a word length of 16 bits, by the A/D converter 130. In addition, the D/A converter 131 converts an outputted signal from the signal processing circuit 400 into an analog audio signal, and outputs the analog audio signal to the adder 800. Finally, the adder 800 adds the inputted signal, which is an analog audio signal, to a D/A converted band-extended signal, and outputs an audio signal having an addition result.

The audio signal band extending apparatus 100-2 configured as stated above exhibits not only the functions and advantageous effects according to the audio signal band extending apparatus 100-1 shown in Fig. 1, but also such a unique advantageous effect, that by executing the respective processings of the bandpass filter (BPF) 200, the level correlated white noise generator circuit 300, and the signal processing circuit 400 by digital signal processings, the respective processings can be designated and executed by software using a digital signal processor (referred to as a DSP hereinafter) or the like, and a configuration of a hardware can be simplified as compared with the prior art. In addition, in this case, by changing the software, contents of the processing executed by the digital signal processings can be easily changed.

## THIRD PREFERRED EMBODIMENT

Fig. 3 is a block diagram showing a configuration of an audio signal band extending apparatus 100-3 according to a third preferred embodiment of the present invention. The audio signal band extending apparatus 100-3 according to the third preferred embodiment is different from the audio signal band extending apparatus 100-1 shown in Fig. 1 in the following points:

(1) The inputted signal X and outputted signal W are digital audio signals;
(2) Processings in the audio signal band extending apparatus 100-3 are all executed by digital signal processings; and
(3) At the prior stage of the bandpass filter (BPF) 200 and the adder 800, an oversampling type low-pass filter (LPF) 120 is inserted.

The differences will be described in detail hereinafter.

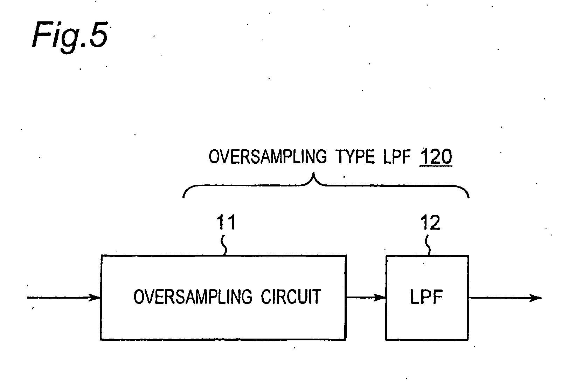

Referring to Fig. 3, the inputted signal X that is the digital audio signal is inputted to the oversampling type LPF 120 via the input terminal 101. This digital audio signal is reproduced from, for example, a compact disk (CD), and in this case, the digital audio signal has a sampling frequency fs of 44.1 kHz and a word length of 16 bits. As shown in Fig. 5, the oversampling type LPF 120 is constructed by including an oversampling circuit 11 and a digital low-pass filter (LPF) 12. The oversampling type LPF 120 is such a digital filter circuit that multiplies a sampling frequency fs of the digital audio signal inputted via the input terminal 101 1 by "p" (where "p" is a positive integer equal to or larger than 2), and attenuates a signal fallen within unnecessary band that extends from a frequency of fs/2 to a frequency of pfs/2 by 60 dB or larger.

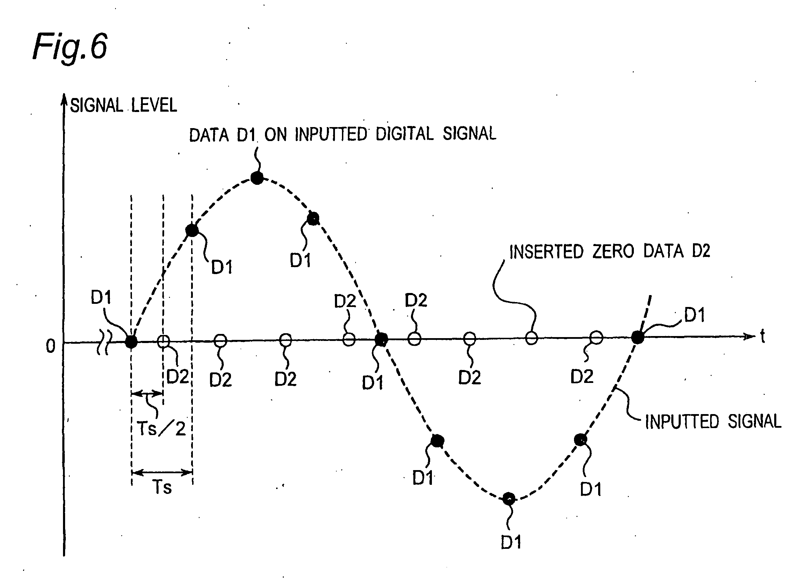

When the "p" is, for example, 2, the digital audio signal having the sampling frequency fs (having a sampling cycle Ts = 1/fs) is inputted to the oversampling circuit 11. As shown in Fig. 6, the oversampling circuit 11 executes an oversampling processing on data D1 of an inputted digital audio signal by inserting "zero" data D2 into intermediate positions (relative to time axis) of respective two D 1 data adjacent to each other at the sampling cycle Ts so as to interpolates the data D1, and converts the inputted digital audio signal into a digital audio signal having a sampling frequency 2fs (having a sampling cycle Ts/2). Finally, the oversampling circuit 11 outputs a resultant digital audio signal to the digital low-pass filter 12. The digital low-pass filter 12 has the following:

(a) a passband that extends from frequency of 0 to 0.45fs;
(b) a stop band that extends from frequency of 0.45 fs to fs; and

(c) an attenuation amount of equal to or larger than 60 dB at a frequency equal to or higher than fs. The digital low-pass filter 12 limits a band of an inputted digital audio signal so as to remove an aliasing noise generated by the oversampling processing by low-pass filtering the inputted digital audio signal, and passes only an effective band (that extends from frequency of 0 to 0.45fs) which the inputted digital audio signal substantially has. Then, the digital low-pass filter 12 outputs a resultant signal to the adder 800 shown in Fig. 3 and the bandpass filter 200.

Further, the adder 800 adds an oversampled low-pass filtered digital audio signal and the low-pass filtering processing to a digital band-extended signal from the signal processing circuit 400, and outputs an audio signal having an addition result as the outputted signal W.

The audio signal band extending apparatus 100-3 configured as stated above exhibits not only the functions and advantageous effects according to the audio signal band extending apparatuses 100-1 and 100-2 shown in Figs. 1 and 2, but also such a unique advantageous effect, that by executing all of the processings by digital signal processings, the respective processings can be designated and executed by software using a digital signal processor or the like, and a configuration of a hardware can be simplified as compared with the prior art. In addition, in this case, by changing the software, contents of the processing executed by the digital signal processings can be easily changed. Further, since the oversampling type low-pass filter 120 is employed to execute the oversampling processing and the low-pass filtering processing on the inputted signal X, the audio signal band extending apparatus 100-3 exhibits the following advantageous effects:

(1) A lower-order analog low-pass filter can be provided at the previous stage of the A/D converter, and this leads to extremely large reduction in the phase distortion and the noise accompanied by the filtering processing;
(2) A quantized noise can be reduced, and conversion at a low quantization bit rate can be easily performed; and
(3) A higher-order higher harmonic wave component of the inputted signal X can be generated in advance and used, and therefore the higher-order higher harmonic wave component can be easily generated.

FOURTH PREFERRED EMBODIMENT

Fig. 4 is a block diagram showing a configuration of an audio signal band extending apparatus 100-4 according to a fourth preferred embodiment of the present invention. The audio signal band extending apparatus 100-4 according to the fourth preferred embodiment is different from the audio signal band extending apparatus 100-3 shown in Fig. 3 in the following points:

(1) The oversampling type low-pass filter 120 is inserted between the input terminal 101 and the adder 800; and
(2) An oversampling circuit 121 is inserted between the level correlated white noise generator circuit 300 and the signal processing circuit 400.

The differences will be described in detail hereinafter.
Referring to Fig. 4, the oversampling type low-pas filter 120 executes the oversampling processing and the low-pass filtering processing on the inputted signal X, and outputs a resultant signal to the adder 800. In addition, the oversampling circuit 121 executes an oversampling processing on the white noise signal outputted from the level correlated white noise generator circuit 300, and outputs a resultant signal to the signal processing circuit 400. Accordingly, it is possible to set signal rates of circuits provided at the subsequent stage of the oversampling type low-pass filter 120 and the oversampling circuit 121 to higher signal rates. In other words, In other words, signal rates of circuits provided at the previous stage of the oversampling type LPF 120 and the oversampling circuit 121 to lower signal rates, and this leads to simplification of the circuit configuration. The audio signal band extending apparatus 100-4 configured as stated above exhibits functions and advantageous effects similar to those according to the audio signal band extending apparatus 100-3 according to the third preferred embodiment.

FIRST IMPLEMENTAL EXAMPLE

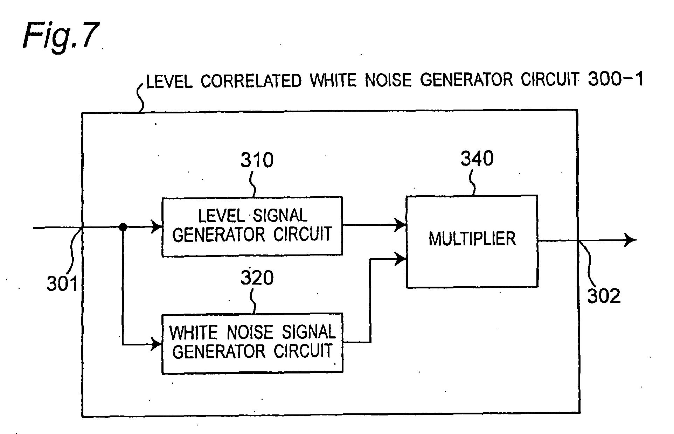

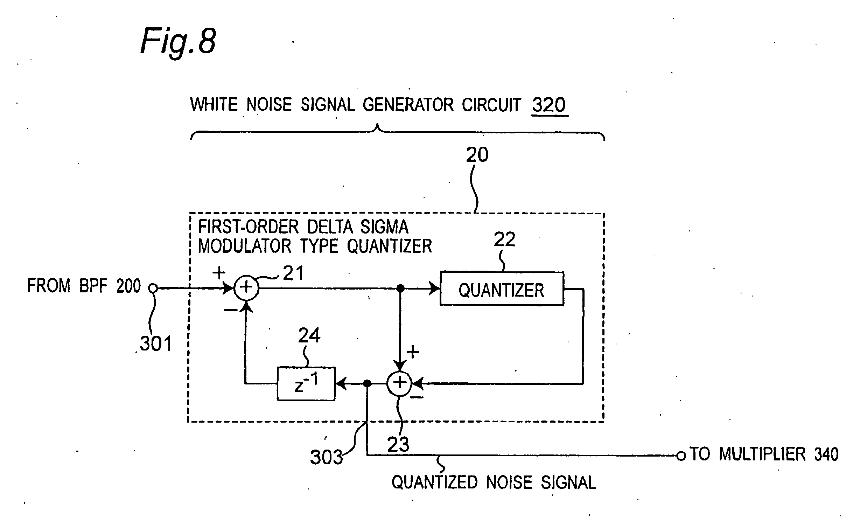

Fig. 7 is a block diagram showing a configuration of a level correlated white noise generator circuit 300-1 according to a first implemental example of the level correlated white noise generator circuit 300 shown in Figs. 1 to 4. Referring to Fig. 7, the level correlated white noise generator circuit 300-1 includes the input terminal 301 and output terminal 302, and is characterized by being constructed to include a level signal generator circuit 310, a white noise signal generator circuit 320, and a multiplier 340.
Referring to Fig. 7, an audio signal having a predetermined partial band is inputted to the level signal generator circuit 310 and the white noise signal generator circuit 320 via the input terminal 301. The level signal generator circuit 310 detects a level of an inputted audio signal, generates a level signal having a detected level, and outputs the level signal to the multiplier 340. A concrete example of the level signal generator circuit 310 is a higher-order bits cutting-out circuit 311 shown in Figs. 9 to 12. Since higher-order bits of an inputted signal indicate a level of the inputted signal, a signal of bits outputted from the higher-order bits cutting-out circuit 311 indicates an approximate level of the inputted signal. The white noise signal generator circuit 320 is constructed by including, for example, a first-order delta sigma modulator type quantizer 20 shown in Fig. 8, generates a white noise signal having a substantially fixed level, which is not correlated to a level of an inputted signal, and outputs the white noise signal to the multiplier 340. Finally, the multiplier 340 multiplies an inputted white noise signal by an inputted level signal to generate a white noise signal, whose level is changed according to the level signal, and outputs the white noise signal via the output terminal 302.

Fig. 8 is a block diagram showing a configuration of the white noise signal generator circuit 320 shown in Fig. 7. Referring to Fig. 8, the white noise signal generator circuit 320 is constructed by the first-order delta sigma modulator type quantizer 20, and the quantizer 20 is constructed by including a subtracter 21, a quantizer 22 for quantization, a subtracter 23, and a delay circuit 24 for delaying a signal by one sample.

Referring to Fig. 8, an inputted signal from the bandpass filter 200 is outputted to the subtracter 21 via the input terminal 301. The subtracter 21 subtracts an audio signal from the delay circuit 24 from an audio signal from the bandpass filter 200, and outputs an audio signal having a subtraction result to the subtracter 21 1 via the delay circuit 24. The audio signal having the subtraction result outputted from the subtracter 23 is a quantized noise signal that indicates a quantized noise generated during the quantization. The quantized noise signal is outputted to the multiplier 340 via the output terminal 303. In the first-order delta sigma modulator type quantizer 20 configured as shown in Fig. 8, a modulated signal, which is first-order delta-sigma modulated, can be generated based on a digital audio signal from the oversampling type low-pass filter 120, that is, a noise signal that is a band signal generated based on the audio signal of the original sound can be generated.

In the white noise signal generator circuit 320 shown in Fig. 8, the first-order delta sigma modulator type quantizer 20 is employed. However, the present invention is not limited to this, and a plural-order delta-sigma modulator type quantizer may be employed. In addition, a sigma delta modulator type quantizer that that subjects an inputted audio signal to a sigma-delta modulation may be employed instead of the delta sigma modulator type quantizer.

SECOND IMPLEMENTAL EXAMPLE

Fig. 9 is a block diagram showing a configuration of a level correlated white noise generator circuit 300-2 according to a second implemental example of the level correlated white noise generator circuit 300 shown in Figs. 1 to 4. Referring to Fig. 9, the level correlated white noise generator circuit 300-2 includes the input terminal 301 and output terminal 302, and is constructed by including the higher-order bits cutting-out circuit 311, a lower-order bits cutting-out circuit 321, and the multiplier 340. In this case, the higher-order bits cutting-out circuit 311 cuts out, for example, ten higher-order bits (b0-b9) out of an inputted signal inputted via the input terminal 301 as shown in Fig. 16A or 16B, and outputs a signal of the ten bits to the multiplier 340 as a level detection signal. In this case, a most significant bit b0 is a sign bit "P". In addition, the lower-order bits cutting-out circuit 321 cuts out, for example, eight lowest-order bits (b16-b23) as shown in Fig. 16A, or cuts out, for example, predetermined lower-order bits (b8-b15) lower than the above-stated higher-order bits as shown in Fig. 16B out of the inputted signal inputted via the input terminal 301. Then, the lower-order bits cutting-out circuit 321 generates a signal of the eight bits as a white noise signal that correlates to the inputted signal but that is changed at random, and outputs the signal of the eight bits to the multiplier 340. Finally, the multiplier 340 multiplies an inputted white noise signal by an inputted level signal to generate a white noise signal whose level is changed according to the level signal and outputs the white noise signal via the output terminal 302.

In the case shown in Fig. 16B, in such a case where lower-order bits, that are lower than a predetermined word length, of the inputted signal X are rounded so that data of the lower-order bits becomes fixed data, and bits in an intermediate part included within a range of the effective word length are cut out by a predetermined bit width.

THIRD IMPLEMENTAL EXAMPLE

Fig. 10 is a block diagram showing a configuration of a level correlated white noise generator circuit 300-3 according to a third implemental example of the level correlated white noise generator circuit 300 shown in Figs. 1 to 4. Referring to Fig. 10, the level correlated white noise generator circuit 300-3 includes the input terminal 301 and the terminal 302, and is constructed by including the higher-order bits cutting-out circuit 311, an intermediate-order bits cutting-out circuit 331, the lower-order bits cutting-out circuit 321, and the multiplier 340. In this case, the higher-order bits cutting-out circuit 311 cuts out, for example, the ten higher-order bits (b0-b9) out of the inputted signal inputted via the input terminal 301 as shown in Fig. 17A, and outputs the signal of the ten bits to the multiplier 340 as the level detection signal. In addition, the intermediate-order bits cutting-out circuit 331 cuts out, for example, six intermediate-order bits (b10-b15) out of the inputted signal inputted via the input terminal 301 as shown in Fig. 17A. Then, intermediate-order bits cutting-out circuit 331 generates a signal of the six bits as a white noise signal that correlates to the inputted signal but that is changed at random, and outputs the signal of the six bits to the multiplier 340 via an adder 330. Further, the lower-order bits cutting-out circuit 321cuts out, for example, eight lower-order bits (b15-b23) out of the inputted signal inputted via the input terminal 301 as shown in Fig. 17A. Then, the lower-order bits cutting-out circuit 321 generates a signal of the eight bits as a white noise signal that correlates to the inputted signal but that is changed at random, and outputs the signal of the eight bits to the multiplier 340 via the adder 330. Finally, the multiplier 340 multiplies two inputted white noise signals by the inputted level signal to generate a white noise signal whose level is changed according to the level signal and outputs the white noise signal via the output terminal 302.

FOURTH IMPLEMENTAL EXAMPLE

Fig. 11 is a block diagram showing a configuration of a level correlated white noise generator circuit 300-4 according to a fourth implemental example of the level correlated white noise generator circuit 300 shown in Figs. 1 to 4. Referring to Fig. 11, the level correlated white noise generator circuit 300-4 includes the input terminal 301 and output terminal 302, and is constructed by including the higher-order bits cutting-out circuit 311, three lower-order bits cutting-out circuits 321, 322, and 323, and the multiplier 340. In this case, the higher-order bits cutting-out circuit 311 cuts out, for example, the ten higher-order bits (b0-b9) out of the inputted signal inputted via the input terminal 301 as shown in Fig. 17B, and outputs the signal of the ten bits to the multiplier 340 as the level detection signal. In addition, the lower-order bits cutting-out circuit 321cuts out, for example, six lower-order bits (b16-b21) out of the inputted signal inputted via the input terminal 301 as shown in Fig. 17B. Then, the lower-order bits cutting-out circuit 321 generates a signal of the six bits as a white noise signal that correlates to the inputted signal but that is changed at random, and outputs the signal of the six bits to the multiplier 340 via the adder 330. Further, the lower-order bits cutting-out circuit 322 cuts out, for example, six lower-order bits (b17-b22) out of the inputted signal inputted via the input terminal 301 as shown in Fig. 17B. Then, the lower-order bits cutting-out circuit 322 generates a signal of the six bits as a white noise signal that correlates to the inputted signal but that is changed at random, and outputs the signal of the six bits to the multiplier 340 via the adder 330. Still further, the lower-order bits cutting-out circuit 323cuts out, for example, six lower-order bits (b18-b23) out of the inputted signal inputted via the input terminal 301 as shown in Fig. 17B. Then, the lower-order bits cutting-out circuit 321 generates a signal of the six bits as a white noise signal that correlates to the inputted signal but that is changed at random, and outputs the signal of the six bits to the multiplier 340 via the adder 330. Finally, the multiplier 340 multiplies three inputted white noise signals by the inputted level signal to generate a white noise signal whose level is changed according to the level signal and outputs the white noise signal via the output terminal 302.

FIFTH IMPLEMENTAL EXAMPLE

Fig. 12 is a block diagram showing a configuration of a level correlated white noise generator circuit 300-5 according to a fifth implemental example of the level correlated white noise generator circuit 300 shown in Figs. 1 to 4. Referring to Fig. 12, the level correlated white noise generator circuit 300-5 includes the input terminal 301 and output terminal 302, and is constructed by including the higher-order bits cutting-out circuit 311, the lower-order bits cutting-out circuit 321, an independent white noise generator circuit 380, an adder 330, and the multiplier 340. Accordingly, the level correlated white noise generator circuit 300-5 is characterized by further including the independent white noise generator circuit 380 and the adder 330, as compared with the level correlated white noise generator circuit 300-2 shown in Fig. 9. The differences will be described in detail hereinafter.

Fig. 13 is a block diagram showing a configuration of the independent white noise generator circuit 380 shown in Fig. 11. Referring to Fig. 13, the independent white noise generator circuit 380 is constructed by including a plurality of "N" PN sequence noise signal generator circuits 30-n (n = 1, 2, ..., N), an adder 31, a constant signal generator for DC offset removal 32, and a subtracter 33, and characterized by generating a noise signal which is independent of the inputted signal X. In this case, the PN sequence is an abbreviation of a pseudo noise sequence. Respective PN sequence noise signal generator circuits 30-n have independent initial values, generate pseudo noise (PN) signals having uniformly random amplitude levels, for example, M sequence noise signals, and output generated PN signals to the adder 31. Next, the adder 31 adds up a plurality of "N" PN signals outputted from the respective PN sequence noise signal generator circuits 30-1 to 30 N so as to obtain a PN signal, and outputs the PN signal having an addition result to the subtracter 33. On the other hand, the constant signal generator for DC offset removal 32 generates a constant signal for DC offset removal, which has a sum of time averaged values of the PN signals from a plurality of "N" PN sequence noise signal generator circuits 30-1 to 30-N, and outputs a generated signal to the subtracter 33. Then, the subtracter 33 subtracts the constant signal for DC offset removal from a sum of the PN signals so as to generate a dither signal without a DC offset, and outputs the dither signal.

In this case, as shown in Fig. 14, each of PN sequence noise signal generator circuits 30-n (n = 1, 2, ..., N) is constituted by including a 32-bit counter 41, an exclusive-OR gate 42, a clock signal generator 43, and an initial value data generator 44. An initial value of 32 bits is set into the 32-bit counter 41 by the initial value data generator 44. The initial values of 32 bits for the respective PN sequence noise signal generator circuits 30-n are different from each other, and then the 32-bit counter 41 counts so as to increment by one according to a clock signal generated by the clock signal generator 43. Among data of 32 bits (including data of 0th bit to data of 31st bit) of the 32-bit counter 41, one-bit data of most significant bit (MSB; 31st bit) and one-bit data of the 3rd bit are inputted to an input terminal of the exclusive-OR gate 42. The exclusive-OR gate 42 sets one-bit data of a calculated exclusive logical sum to a least significant bit (LSB) of the 32-bit counter 41. Finally, data of lower eight bits of the 32-bit counter 41 is outputted as a PN sequence noise signal. By thus constituting the PN sequence noise signal generator circuits 30-n, PN sequence noise signals outputted from the respective PN sequence noise signal generator circuits 30-n become the eight-bit PN sequence noise signals independent of one another.

In the example shown in Fig. 14, the PN sequence noise signal generator circuits 30-n are constituted as described above so as to generate the eight-bit PN sequence noise signals independent of one another. However, the present invention is not limited to this. The PN sequence noise signal generator circuits 30-n may be constituted as follows.

(1) The bit locations of eight-bit in 32-bit counter 41, from which the PN sequence noise signals are taken out, are set to be different from each other. Namely, the PN sequence noise signal generator circuit 30-1 takes out an eight-bit PN sequence noise signal from the least significant eight bits, the PN sequence noise signal generator circuit 30-2 takes out a PN sequence noise signal from eight bits right on the least significant eight bits, and the subsequent PN sequence noise signal generator circuits take out PN sequence noise signals in a manner similar to above.
(2) Instead, the bit locations of the respective 32-bit counters 41, from which one-bit data inputted to corresponding exclusive-OR gates 42 are taken out, are set to be different from each other.
(3) Alternatively, at least two of the example shown in Fig. 14, a modified example as described in (1), and a modified example as described in (2) are combined.

By adding up a plurality of PN sequence noises independent of one another, a PN sequence noise signal having a probability density relative to an amplitude level can be generated as shown in Figs. 18A, 18B, and 18C, according to number "N" of the PN sequence noise signal generator circuits 30. If "N" is 1, for example, a white noise signal generally having such a probability density that is uniformly distributed relative to the amplitude level can be generated. In addition, if "N" is 12, by adding up the PN sequence noise signals from the respective PN sequence noise signal generator circuits 30-n that generate twelve uniformly random numbers, a Gaussian distribution type noise signal generally having a probability density of the Gaussian distribution relative to the amplitude level can be generated as shown in Fig. 18A, since a Gaussian distribution has a dispersion of 1/12 according to the central limit theorem. Further, if "N" is 3, a bell distribution type (hanging bell type) noise signal having a probability density of a bell distribution or a hanging bell distribution similar to the Gaussian distribution and having a slightly greater dispersion than that of the Gaussian distribution, relative to the amplitude level can be generated as shown in Fig. 18C. As described so far, by constructing circuits as shown in Figs. 13 and 14 and generating a noise signal shown in, for example, Fig. 18B or 18C, a dither signal similar to a natural sound or a musical sound signal can be generated using such a circuit that is small in size.

Referring back to Fig. 12, the random noise signal from the lower-order bits cutting-out circuit 321 is outputted to the adder 330. On the other hand, the independent white noise generator circuit 380, which has the configuration at N = 1 in Fig. 13 as stated above, generates the white noise signal, and outputs the white noise signal to the adder 330. The adder 330 adds up two inputted noise signals, and outputs a noise signal having an addition result to the multiplier 340. In the level correlated white noise generator circuit 300-5 shown in Fig. 12, the noise signal has a level-correlation to the inputted signal. However, the level correlated white noise generator circuit 300-5 can generate a white noise signal having a reduced level correlation, since the white noise signal from the independent white noise generator circuit 380 is also used.

SIXTH IMPLEMENTAL EXAMPLE

Fig. 15 is a block diagram showing a configuration of a level correlated white noise generator circuit 300-6 according to a sixth implemental example of the level correlated white noise generator circuit 300 shown in Figs. 1 to 4. The level correlated white noise generator circuit 300-6 shown in Fig. 15 is characterized by including a diamond dithering noise generator circuit 381 instead of the independent white noise generator circuit 380, as compared with the level correlated white noise generator circuit 300-5. In this case, the diamond dithering noise generator circuit 381 is constructed by having a configuration of the white noise generator circuit 380 shown in Fig. 13 at N=2, and generates and outputs a diamond noise signal having the probability density of the amplitude level shown in Fig. 18B. In the level correlated white noise generator circuit 300-6 shown in Fig. 15, similarly to the white noise generator circuit 300-5 shown in Fig. 12, the noise signal has a level-correlation to the inputted signal. However, the level correlated white noise generator circuit 300-6 can generate the white noise signal having the reduced level correlation, since the white noise signal from the independent white noise generator circuit 380 is also used.

SEVENTH IMPLEMENTAL EXAMPLE

Fig. 19 is a block diagram showing a configuration of a level correlated white noise generator circuit 300-7 according to a seventh implemental example of the level correlated white noise generator circuit 300 shown in Figs. 1 to 4. The level correlated white noise generator circuit 300-7 shown in Fig. 19 is constructed by including a non-uniformity quantizer 351 for quantizing an inputted signal non-uniformly relative to a level of the inputted signal, a dequantizer 361 for executing quantization that is opposite to the quantization executed by the non-uniformity quantizer 351, and a subtracter 371. In this case, the non-uniformity quantizer 351 executes the quantization using, for example, run-length 1/N compression floating coding.

Referring to Fig. 19, an inputted signal (in this case, the inputted signal is an audio signal having a sampling frequency fs of 44.1 Hz and a word length of 16 bits) inputted via an input terminal 301 is inputted to the subtracter 371 and the non-uniformity quantizer 351. The non-uniformity quantizer 351 compresses the word length of the inputted signal of 16 bits into 1/N thereof, and thereafter outputs a compressed signal to the dequantizer 361. A method for the compression will be described later in detail. The dequantizer 361 dequantizes the compressed signal so as to exhibit a compression characteristic that is opposite to that of the non-uniformity quantizer 351, and extends the compressed signal to a signal of 16 bits. A re-quantized signal requantized by the non-uniformity quantizer 351 and the dequantizer 361 is outputted to the subtracter 371. The subtracter 371 outputs a quantized noise signal, which is a differential signal between a re-quantized inputted signal and the original inputted signal, via an output terminal 302.

By configuring the level correlated white noise generator circuit 300-7 as shown in Fig. 19, by calculating a difference between an outputted signal from the dequantizer 361 and the inputted signal, the difference becomes a quantized noise, and a value of the difference is changed according to the level of the inputted signal. As a result, a level-correlated noise signal can be obtained.

Various characteristics of a quantized noise signal generated by the level correlated white noise generator circuit 300-7 shown in Fig. 19 will be described in detail. Cause of the quantized noise is an error signal created by a roughness of a quantization scale. Fig. 21 is a diagram showing a characteristic of an instantaneous S/N ratio relative to the level of the inputted signal showing such a case where the non-uniformity quantizer 351 and the dequantizer 361 shown in Fig. 19 are combined. In Fig. 21, a vertical axis indicates the instantaneous S/N ratio. The instantaneous S/N is a signal to noise distortion factor in a signal band from 0 Hz to 44.1 kHz or the Nyquist frequency (which is a sampling frequency limit at which no aliasing occurs to a signal, and which satisfies a relationship of (Nyquist frequency) = (sampling frequency) in an ideal state of zero margin in the present preferred embodiment). As apparent from Fig. 21, as compared with linear coding (8 bits, 16 bits, and 24 bits) according to the prior art, the instantaneous S/N ratio can be greatly improved relative to almost all input levels. As a concrete compression method of the non-uniformity quantizer 351, the run-length 1/N compression floating coding method is used as stated above.

Next, the run-length 1/N compression floating coding method will be described with reference to Fig. 23A. According to this coding method, a linear code of "L" bits is inputted to the non-uniformity quantizer 351 which is a coder. In this case, the linear code of "L" bits is present in a higher-order part of a linear code that is original data to be coded, and constituted by a polarity bit P, continuous data Q0 of continuous bits each having a predetermined logic, an inverted bit T0 that breaks the continuity of the continuous data Q0, and lower-order data D0 following the inverted bit T0. The non-uniformity quantizer 351 converts the linear code of "L" bits into a compressed data of "M" bits and outputs the compressed data of "M" bits. In this case, the compressed data of "M" bits is constituted by a sign bit P and compressed continuous data Q1 obtained by compressing a run length of the continuous data Q0, an inverted bit T1 that breaks the continuity of the compressed continuous data Q1, compressed residual data F1 that represents a residue generated upon compressing the run length, and mantissa data D1 obtained by rounding the lower-order data D0. Provided that the run length of the continuous data Q0 is L0, the run length of the compressed continuous data Q1 is L1, and "n" is an integer equal to or larger than 2, the run length L1 and the compressed residual data F1 are expressed by the following equations, respectively:

$$L1 = Int\,(L0/N), \qquad (1)$$

and

$$F1 = L0\ mod\ N \qquad (2).$$

In this case, "Int" is a function that represents an integer value of an argument, and "A mod B" is a function that represents a residue obtained when "A" is divided by "B".

Next, in the dequantization processing executed by the dequantizer 361, the above-stated dequantization processing is executed using a reverse conversion processing of the run-length 1/N compression floating coding. The dequantization will be described with reference to Fig. 23B.

The dequantizer 361 extends compressed data so as to generate and output extended data. In this case, the compressed data is constituted by the polarity bit P and the compressed continuous data Q1 of the continuous bits having the predetermined logic in the higher-order part, the inverted bit T1 that breaks the continuity of the compressed continuous data Q1, the compressed residual data F1 that represents the residue generated upon compressing the run length, and the mantissa data D1. The dequantizer 361 extends the compressed data by extending the run length of the Q1 by "N" times, adding continuous data having a length corresponding to a value of the data F1, adding the inverted bit T0 for breaking the continuity of the Q0, further adding the mantissa data D 1 to a resultant data, and reading out the continuous data Q0, the inverted bit T0, and the mantissa data D0. Provided that the run length of the continuous data Q0 is L0, the run length of the compressed continuous data Q1 is L1, the residue obtained from the compressed residual data F1 is F1, and "N" is an integer equal to or larger than 2, the run length L0 and the mantissa data D0 are expressed by the following equations, respectively:

$$LO = L1*n+F1, \qquad (3)$$

and

$$DO = D1 \qquad (4).$$

In this case, * is an arithmetic symbol that represents multiplication.

The compression method and compression apparatus based on the above-stated run-length 1/N compression floating coding are concretely described in Japanese patent laid-open publication No. 4-286421, Japanese patent laid-open publication No. 5-183445, and Japanese patent laid-open publication No. 5-284039, respectively. Calculation results and resolution thereof in such a case where a linear code of 24 bits is compressed to a compressed code of eight bits and a run length of 1/4 are shown in Table 1.

Referring to Table 1, the linear code of 24 bits is an aliasing binary code, and the floating code is an aliasing run-length 1/4 compressed floating code. In the columns of the run length L0, the run length L1, and the resolution in Table 1, each value is represented decimally. An expression accuracy, that is a resolution, of a decoded code (a dequantized signal) obtained by decoding (dequantizing) and extending the compressed code (a non-uniformly quantized signal) is determined by rounding of the linear code, and changed according to the run length L0. As apparent from Table 1, the highest accuracy of 24 to 15 bits is obtained. In addition, calculation results arranged so as to be suitable for numeric conversion and table conversion using the DSP are shown in Tables 2 and 3.

Table 2 is a non-uniformity quantization conversion table. In Table 2, "X" is a non-uniformly quantized input code and "W" is a non-uniformly quantized output code. When a code length of the output code "W" exceeds 24, the code length is rounded to 24. When the code length of the input code "X" is insufficient, "0" is inserted to a lower-order part of the input code "X". Table 2 also shows effective bits and quantized noise. As apparent from Table 2, the effective bits range from six bits to 24 bits, and the quantized noise has a value from -36 dB to - 144 dB as shown in Fig. 22. Table 3 shows the quantized noise (24 bits) corresponding to respective linear codes of 24 bits.

Table 1

| LINEAR CODE 24 BITS | | RUN-LENGTH 1/4 COMPRESSED FLOATING CODE 8 BITS | | RESOLUTION BITS |
|---|---|---|---|---|
| L0 | 000000000011111111112222 012345678901234567890123 (MSB          LSB) | L1 | 01234567 (MSB LSB) | |
| 0 | P1ABCD################ | 0 | P111ABCD | 6 |
| 1 | P01ABCD################ | 0 | P110ABCD | 7 |

# EP 1 653 627 B1

(continued)

| | | 8 BITS | | BITS |
|---|---|---|---|---|
| 2 | P001ABCD################ | 0 | P101ABCD | 8 |
| 3 | P0001ABCD############### | 0 | P100ABCD | 9 |
| 4 | P00001ABC############### | 1 | P0111ABC | 9 |
| 5 | P000001ABC############## | 1 | P0110ABC | 10 |
| 6 | P0000001ABC############# | 1 | P0101ABC | 11 |
| 7 | P00000001ABC############ | 1 | P0100ABC | 12 |
| 8 | P000000001AB############ | 2 | P00111AB | 12 |
| 9 | P0000000001AB########### | 2 | P00110AB | 13 |
| 10 | P00000000001AB########## | 2 | P00101AB | 14 |
| 11 | P000000000001AB######### | 2 | P00100AB | 15 |
| 12 | P0000000000001A######### | 3 | P000111A | 15 |
| 13 | P00000000000001A######## | 3 | P000110A | 16 |
| 14 | P000000000000001A####### | 3 | P000101A | 17 |
| 15 | P0000000000000001A###### | 3 | P000100A | 18 |
| 16 | P00000000000000001###### | 4 | P0000111 | 18 |
| 17 | P000000000000000001##### | 4 | P0000110 | 19 |
| 18 | P0000000000000000001#### | 4 | P0000101 | 20 |
| 19 | P00000000000000000001### | 4 | P0000100 | 21 |
| 20 | P000000000000000000001## | 5 | p0000011 | 22 |
| 21 | P0000000000000000000001# | 5 | P0000010 | 23 |
| 22 | P00000000000000000000000A | 5 | P000000A | 24 |

Table 2

| $|X| =$ | $|W| =$ | EFFECTIVE BITS | QUANTIZED NOISE |
|---|---|---|---|
| $2^{-1} \leqq |X|$ | $2^{-1}+2^{-2}+2^{-2*}|X|$ | 6 | -36[dB] |
| $2^{-2} \leqq |X| < 2^{-1}$ | $2^{-1}+2^{-3}+2^{-1*}|X|$ | 7 | -4D[dB] |
| $2^{-3} \leqq |X| < 2^{-2}$ | $2^{-1}+2^{-0*}|X|$ | 8 | -48[dB] |
| $2^{-4} \leqq |X| < 2^{-3}$ | $2^{-2}+2^{-3}+2^{1}*|X|$ | 9 | -54[dB] |
| $2^{-5} \leqq |X| < 2^{-4}$ | $2^{-2}+2^{-3}+2^{1*}|X|$ | 9 | 54[dB] |
| $2^{-6} \leqq |X| < 2^{-5}$ | $2^{-2}+2^{-4}+2^{2*}|X|$ | 10 | -60[dB] |
| $2^{-7} \leqq |X| < 2^{-6}$ | $2^{-2}+2^{3*}|X|$ | 11 | -66[dB] |
| $2^{-8} \leqq |X| < 2^{-7}$ | $2^{-3}+2^{-4}+2^{4*}|X|$ | 12 | -72[dB] |
| $2^{-9} \leqq |X| < 2^{-8}$ | $2^{-3}+2^{-4}+2^{4*}|X|$ | 12 | -72[dB] |
| $2^{-10} \leqq |X| < 2^{-9}$ | $2^{-3}+2^{-5}+2^{5*}|X|$ | 13 | -78[dB] |
| $2^{-11} \leqq |X| < 2^{-10}$ | $2^{-3}+2^{6*}|X|$ | 14 | -84[dB] |
| $2^{-12} \leqq |X| < 2^{-11}$ | $2^{-4}+2^{-5}+2^{7*}|X|$ | 15 | -90[dB] |
| $2^{-13} \leqq |X| < 2^{-12}$ | $2^{-4}+2^{-5}+2^{7*}|X|$ | 15 | -90[dB] |
| $2^{-14} \leqq |X| < 2^{-13}$ | $2^{-4}+2^{-6}+2^{8*}|X|$ | 16 | -96[dB] |
| $2^{-15} \leqq |X| < 2^{-14}$ | $2^{-4}+2^{9*}|X|$ | 17 | -102[dB] |
| $2^{-16} \leqq |X| < 2^{-15}$ | $2^{-5}+2^{-6}+2^{10*}|X|$ | 18 | -108[dB] |
| $2^{-17} \leqq |X| < 2^{-16}$ | $2^{-5}+2^{-6}+2^{10*}|X|$ | 18 | -108[dB] |
| $2^{-18} \leqq |X| < 2^{-17}$ | $2^{-5}+2^{-7}+2^{11*}|X|$ | 19 | -114[dB] |
| $2^{-19} \leqq |X| < 2^{-18}$ | $2^{-5}+2^{12*}|X|$ | 20 | -120[dB] |
| $2^{-20} \leqq |X| < 2^{-19}$ | $2^{-6}+2^{-7}+2^{13*}|X|$ | 21 | -126[dB] |
| $2^{-21} \leqq |X| < 2^{-20}$ | $2^{-6}+2^{-7}+2^{14*}|X|$ | 22 | -132[dB] |
| $2^{-22} \leqq |X| < 2^{-21}$ | $2^{-6}+2^{15*}|X|$ | 23 | -138[dB] |
| $|X| < 2^{-22}$ | $2^{16*}|X|$ | 24 | -144[dB] |

Table 3

| | LINEAR CODE 24 BITS | QUANTIZED NOISE 24 BITS |
|---|---|---|
| L0 | 000000000011111111112222 012345678901234567890123 (MSB                    LSB) | 000000000011111111112222 012345678901234567890123 (MSB                    LSB) |
| 0 | P1ABCD################## | P00000################## |
| 1 | P01ABCD################# | P000000################# |
| 2 | P001ABCD################ | P0000000################ |
| 3 | P0001ABCD############### | P00000000############### |
| 4 | P00001ABC############### | P00000000############### |
| 5 | P000001ABC############## | P000000000############## |
| 6 | P0000001ABC############# | P0000000000############# |
| 7 | P00000001ABC############ | P00000000000############ |
| 8 | P000000001AB########### | P0000000000############ |
| 9 | P0000000001AB########### | P000000000000########### |
| 10 | P0000000001AB########## | P0000000000000########## |
| 11 | P0000000001AB######### | P00000000000000######### |
| 12 | P0000000000001A######### | P000000000000000######## |
| 13 | P00000000000001A######## | P0000000000000000####### |
| 14 | P000000000000001A####### | P0000000000000000####### |
| 15 | P000000000000001A###### | P00000000000000000###### |
| 16 | P0000000000000000001###### | P00000000000000000###### |
| 17 | P00000000000000000001##### | P000000000000000000##### |
| 18 | P000000000000000000001#### | P0000000000000000000#### |
| 19 | P0000000000000000000001### | P0000000000000000000### |
| 20 | P00000000000000000000001## | P00000000000000000000## |
| 21 | P000000000000000000000001# | P000000000000000000000# |
| 22 | P0000000000000000000000A | P00000000000000000000000 |

As apparent from above-mentioned Tables 1, 2 and 3, the run-length 1/N compression floating code used in the present preferred embodiment is characterized by coding by quantizing the inputted signal so that a quantization width increases as the level of the inputted signal is larger.

In the above-stated preferred embodiment, the run length 1/N compression floating coding is used, and the linear code is the aliasing binary code. However, the present invention is similarly applicable to any other linear code such as 2'S complementary code or an offset binary code only by converting the code into another code or changing the predetermined logic value. In addition, only a case where "N" is "4" has been described, however, "N" may be arbitrarily set as long as "N" is an integer "equal to or larger than 2". In this case, a number of cases of the compressed residual data changes according to the value of "N". Accordingly, it is needless to say that a word length of the compressed residual data may be changed. In addition, the apparatus is not always constructed by a hardware circuit and may be constructed by a hardware circuit of the DSP that performs the table conversion and data conversion and a program of software installed into the hardware circuit.

As stated so far, when the run length of the original data is small, an exponent part, that is a range, is represented by fewer bits. When the run length becomes larger, bits are allocated so that the exponent part, that is the range, is represented by larger number of bits. Since the word length of the entire code is a fixed length, the number of bits of the mantissa part is changed according to the run length. These functions can extend an expression space of the range of the compressed code outputted from an output part, and also improve the expression accuracy.

EIGHTH IMPLEMENTAL EXAMPLE

Fig. 20 is a block diagram showing a configuration of a level correlated white noise generator circuit 300-8 according to an eighth implemental example of the level correlated white noise generator circuit 300 shown in Figs. 1 to 4. The level correlated white noise generator circuit 300-8 shown in Fig. 20 has such a configuration that three white noise generator circuits 385-1, 385-2, and 385-3, each configured by the level correlated white noise generator circuit 300-7 shown in Fig. 19, are connected in parallel, and obtains a noise signal by adding up outputted signals from the respective whit noise generator circuits 385-1, 385-2, and 385-3 by an adder 374. The level correlated white noise generator circuit 385-1 is constructed by including the non-uniformity quantizer 351, the dequantizer 361, and the subtracter 371. The level correlated white noise generator circuit 385-2 is constructed by including a non-uniformity quantizer 352, dequantizer 362, and a subtracter 372. The level correlated white noise generator circuit 385-3 is constructed by including a non-uniformity quantizer 353, a dequantizer 363, and a subtracter 373. These three level correlated white noise generator circuits 385-1, 385-2, and 385-3 have configurations similar to each other, and generate three noise signals similar to each other. The adder 374 adds up the three noise signals so as to be able to generate a noise signal having a probability density of, for example, the bell noise signal shown in Fig. 18C.

NINTH IMPLEMENTAL EXAMPLE

Fig. 24 is a block diagram showing a configuration of a level correlated white noise generator circuit 300-9 according to a ninth implemental example of the level correlated white noise generator circuit 300 shown in Figs. 1 to 4. The level correlated white noise generator circuit 300-9 is constructed by including a table converter circuit 390 that stores a table memory 390a in it. The table memory 390a includes data representing a relationship between the inputted signal and outputted signal of Fig. 19 or 20, that is, a data table representing values of outputted signals relative to all inputted signals. The level correlated white noise generator circuit 300-9 receives the inputted signal inputted via the input terminal 301, responsive to the inputted signal inputted to the input terminal 301, refers to the table memory 390a to search a value of an outputted signal corresponding to a value of the inputted signal, generates an outputted signal that is a noise signal having a value of an outputted signal having a search result, and outputs a resultant outputted signal via the output terminal 302. As stated above, according to the level correlated white noise generator circuit 300-9 shown in Fig. 24, a level correlated white noise generator circuit can be constituted with a circuit having an extremely simple configuration as compared with the configurations of the other level correlated white noise generator circuits 300-1 to 300-8.

Fig. 25 is a block diagram showing a configuration of the signal processing circuit 400 shown in Figs. 1 to 4. As shown in Fig. 25, the signal processing circuit 400 is constructed by including a bandpass filter 410, an echo addition circuit 420, and a variable multiplier 430. As shown in Fig. 25, the bandpass filter 410 has such a configuration that a high-pass filter (HPF) 411 and a (1/f) characteristic filter 412, which is a low-pass filter, are connected in cascade to each other.

When the inputted digital audio signal is, for example, an uncompressed digital signal outputted from a CD player or the like, the babdpass filter 410 preferably has the following specifications:

(1) A cutoff frequency fLC on a lower frequency side is about fs/2;
(2) A cutoff characteristic on the lower frequency side is an attenuation amount equal to or larger than 80 dB at a frequency fs/4. The attenuation amount is close to an SN ratio based on a quantization number of the original sound. When the quantization number of the original sound is, for example, 16 bits, a theoretical SN is 98 dB. Accordingly, the babdpass filter 410 preferably has the attenuation amount equal to or larger than 80 to 100 dB. It is noted that softer sound quality is obtained as the cutoff characteristic on the lower frequency side is slower, and that sharper sound quality tendency is obtained as the cutoff frequency on the lower frequency side is sharper. In the latter case, a band extension effect can be exhibited without damaging sound quality tendency of the original sound. Accordingly, it is preferable that the cutoff characteristic on the lower frequency side of the digital low-pass filter 412 can be selectively changed over between, for example, the above-stated two characteristics according to a user's command signal from an external controller;
(3) A cutoff frequency fHC on a higher frequency side is about fs/2; and
(4) A cutoff characteristic on the higher frequency side is -6 dB/oct (See, for example, Fig. 26).

In this case, as shown in Fig. 26, the (1/f) characteristic filter 412 is a so-called (1/f) characteristic low-pass filter that possesses such an attenuation characteristic that an inclination of -6 dB/oct in a band B2 that extends from frequency of fs/2 to p·fs/2, where the band B2 is higher that a band B1 that extends from frequency of 0 to fs/2. It is noted that "p" is an oversampling ratio, for example, an integer equal to or larger than 2 and equal to or smaller than about 8.

The babdpass filter 410 bandpass-filters an inputted digital signal, and outputs a bandpass-filtered digital band-extended signal via the echo addition circuit 420 and the variable amplifier 430 as described above.

The echo addition circuit 420 is constructed by, for example, a transversal filter shown in Fig. 28. The echo addition circuit 420 adds an echo signal having a correlation to an inputted signal to the inputted signal according to a control signal that represents a degree of echo addition and that is inputted from an external circuit, and outputs a resultant signal. In this case, the inputted signal inputted to the echo addition circuit 420 is inputted to "N" delay circuits D1 to DK connected in cascade to each other and each delaying a signal by, for example, one sample of time, and inputted to an adder SU1 via a variable multiplier AP0. In this case, the variable multiplier AP0 multiplies an inputted signal by a multiplication value indicated by a multiplication value command control signal CS0 from a controller 421, generates a signal having a value of a multiplication result, and outputs a generated signal to the adder SU1. In addition, an outputted signal from the delay circuit D1 is outputted to the adder SU1 via a variable multiplier AP1 that multiplies the inputted signal by a multiplication value indicated by a multiplication value command control signal CS1 from the controller 421. Further, the outputted signal from the delay circuit D2 is outputted to the adder SU1 via a variable multiplier AP2 that multiplies the inputted signal by a multiplication value indicated by a multiplication value command control signal CS2 from the controller 421. In a manner similar to above stated manner, the outputted signal from the delay circuit Dk (k = 3, 4, ..., K) is outputted to the adder SU1 via a variable multiplier APk that multiplies the inputted signal by a multiplication value indicated by a multiplication value command control signal CSk from the controller 421. The adder SU1 adds up inputted $(K \pm 1)$ signals, outputs a signal having an addition result to the controller 421, and outputs to the external circuit as an outputted signal. In this case, the controller 421 adds a predetermined echo signal to the inputted signal to the echo addition circuit 420 based on a signal from the adder SU1, to generate multiplication value command control signals CSk (k = 1, 2, ..., K), and output respective signals CSk to the respective variable multipliers AP0 to APK.

The signal processing circuit 400 shown in Fig. 25 includes the echo addition circuit 420. However, the present invention is not limited to this. The signal processing circuit 400 does not necessarily include the echo addition circuit 420.

By providing the echo addition circuit 420 shown in Fig. 25, the echo signal is added only to the band-extended signal. Accordingly, when a magnitude of the inputted signal changes greatly, a sustain effect of smoothing a drop in the magnitude of the inputted signal and sustaining a noise component in a higher frequency range is produced. Due to the sustain effect, the signal sounds more natural. In addition, when the echo addition circuit 420 is not additionally provided, the band-extended signal is added to the inputted signal always interlocking with the change in the magnitude of the inputted signal. Therefore, the signal exhibits the most faithful time spectral characteristic.

In this case, the variable amplifier 430 shown in Fig. 25 is a level control circuit. The variable amplifier 430 changes a level (amplitude value) of an inputted digital signal by an amplification ratio (which is set for a positive amplification processing but may be set for a negative amplification or an attenuation processing) based on a control signal, and outputs a level-changed digital signal as an outputted signal. The variable amplifier 430 is used to relatively adjust levels of two signals inputted to the adder 800. This adjustment is preferably set so that the levels of these two signals substantially coincide with each other, i.e., set so as to keep the spectral continuity thereof, at the frequency of, for example, fs/2 in the adder 800.

Figs. 29A to 29E are frequency spectral views showing an operation of the audio signal band extending apparatus 100-3 (at p = 2, that is during twofold oversampling) according to the third preferred embodiment shown in Fig. 3. Fig. 29A is a frequency spectral view of the inputted signal X, Fig. 29B is a frequency spectral view of the outputted signal from the LPF 120, Fig. 29C is a frequency spectral view of the outputted signal from the circuit 300, Fig. 29D is a frequency spectral view of the outputted signal from the circuit 400, and Fig. 29E is a frequency spectral view of the outputted signal W.

Referring to Figs. 3 and 29A to 29E, the operation of the audio signal band extending apparatus 100-3 will be described. As shown in Figs. 29A and 29B, the inputted signal having a predetermined maximum frequency fmax is oversampled and low-pass filtered by the oversampling type low-pass filter 120, and then bandpass filtered using a bandpass filtering characteristic 200S of the bandpass filter 200, and a resultant frequency spectrum is shown in Fig. 29B. In this case, the maximum frequency fmax of the inputted signal is equal to or lower than fs/2, and when a margin for frequency is set, the maximum frequency fmax is lower than fs/2. Based on the inputted signal from the bandpass filter 200, the level correlated white noise generator circuit 300 generates a white noise signal shown in Fig. 29C, the level of which changes according to the level of the inputted signal i.e., generates a white-noise signal which is level-correlated to the inputted signal. Next, the signal processing circuit 400 executes the bandpass filtering processing, the echo addition processing, and the level adjustment processing on a generated white noise signal, so as to generate a band-extended addition signal shown in Fig 29D. In this case, a lower limit frequency of the band-extended addition signal is fmax. Further, as shown in Fig. 29E, the adder 800 adds up a signal from the oversampling type LPF 120 and a signal from the signal processing circuit 400 so as to keep the spectral continuity thereof at the frequency fmax, and outputs a signal having an addition result as the outputted signal.

Figs. 30A to 30D are frequency spectral views showing an operation of the audio signal band extending apparatus 100-4 (at p = 2, that is during twofold oversampling) according to the fourth preferred embodiment shown in Fig. 4. Fig. 30A is a frequency spectral view of the inputted signal X, Fig. 30B is a frequency spectral view of the outputted signal from the circuit 300, Fig. 30C is a frequency spectral view of the outputted signal from the circuit 400, and Fig. 30D is a frequency spectral view of the outputted signal W. As shown in Figs. 30A to 30D, the audio signal band extending apparatus 100-4 performs an operation similar to that shown in Figs. 29A to 29E except for the following differences.

The differences between the audio signal band extending apparatus 100-3 shown in Fig. 3 and the audio signal band extending apparatus 100-4 shown in Fig. 4 will be described hereinafter. In the audio signal band extending apparatus 100-3 shown in Fig. 3, the inputted signal is oversampled and low-pass filtered, and thereafter the bandpass filtering processing, the noise generation processing, and the signal processing are executed on a resultant signal. In the audio signal band extending apparatus 100-4 shown in Fig. 4, differently from audio signal band extending apparatus 100-3 shown in Fig. 3, the inputted signal is bandpass filtered, and thereafter the noise generation processing is executed on a resultant signal. Due to this difference, a clock rate for putting the bandpass filter 200 and the noise generation circuit 300 into operation can be reduced as compared with such a case where the bandpass filter 200 and the noise generation circuit 300 is provided at the subsequent stage of the oversampling circuit 120 shown in Fig. 3. The audio signal band extending apparatus 100-4 shown in Fig. 4 exhibits such advantages effects that size of circuits can be made small, the clock rate can be reduced, and the number of steps of the DSP processing can be decreased. The signal after the noise generation is oversampled and the signal processing is executed on a resultant signal, while the inputted signal is oversampled. Finally, an oversampled inputted signal is added to the signal after the noise generation. As a result, a signal that is the same as that shown in Fig. 3 can be obtained as the outputted signal W. The audio signal band extending apparatus 100-4 shown in Fig. 4 requires the two oversampling circuits 120 and 121. However, the oversampling circuits 120 and 121 for processing the signal after the noise generation may only interpolate zero in response to the clock signal, and do not require any low-pass filters. Due to this, size of circuits or the like is hardly increased but can be reduced in the end.

Figs. 31A to 31E are frequency spectral views showing an operation of the audio signal band extending apparatus (at p = 4, that is during fourfold oversampling) according to the third preferred embodiment shown in Fig. 3. Fig. 31A is a frequency spectral view of the inputted signal X, Fig. 31B is a frequency spectral view of the outputted signal from the LPF 120, Fig. 31C is a frequency spectral view of the outputted signal from the circuit 300, Fig. 31D is a frequency spectral view of the outputted signal from the circuit 400, and Fig. 31E is a frequency spectral view of the outputted signal W. In addition, Figs. 32A to 32D are frequency spectral views showing an operation of the audio signal band extending apparatus (at p = 4, that is during fourfold oversampling) according to the fourth preferred embodiment shown in Fig. 4. Fig. 32A is a frequency spectral view of the inputted signal X, Fig. 32B is a frequency spectral view of the outputted signal from the circuit 300, Fig. 32C is a frequency spectral view of the outputted signal from the circuit 400, and Fig. 32D is a frequency spectral view of the outputted signal W.

The operation shown in Figs. 31A to 31E is similar to the operation shown in Figs. 29A to 29E except that a multiple number of oversampling in the operation shown in Figs. 31A to 31E is twofold of that of oversampling in the operation shown in Figs. 29A to 29E. In addition, the operation shown in Figs. 32A to 32D is similar to the operation shown in Figs. 30A to 30D except that a multiple number of oversampling in the operation shown in Figs. 32A to 32D is twofold of that of oversampling in the operation shown in Figs. 30A to 30D.

Figs. 33A and 33B show modified examples of Figs. 31A to 31E and 32A to 32D. Fig. 33A is a frequency spectral view showing a characteristic of an aliasing removal filter instead of the (1/f) characteristic filter 412, and Fig. 33B is a spectral view of the outputted signal W. A higher frequency range component in an upper limit frequency characteristic of the generated noise signal is generally removed by a higher frequency range removal characteristic shown in Fig. 26 or 27. However, by employing, for example, the aliasing removal filter shown in Fig. 33A, components at frequencies up to a predetermined frequency exceeding the Nyquist frequency remain, so that the following advantageous effects can be exhibited:

(1) As shown in Fig. 33B, an audio band extension range can be extended to be higher than the Nyquist frequency; and
(2) Since the simplification of the configuration such as a decrease in the number of stages of the aliasing removal filter can be realized, the apparatus can be manufactured at a low cost. In addition, since the number of steps of the processing using the DSP or the like can be decreased, a number of steps per unit time (MIPS) can be decreased.

As described so far, according to the preferred embodiments of the present invention, as shown in Fig. 1, there is generated a noise signal having a level changing according to a level of an inputted signal and correlated to the level of the inputted signal in bands equal to or higher than the band of the inputted signal, and the noise signal is added to the inputted signal so as to keep the spectral continuity thereof. Accordingly, it is possible to easily generate a signal having an extended audio band as compared with the prior art. In addition, a band-extended signal obtained as stated above changes according to a level of an original sound and keeps its spectral continuity. Accordingly, the apparatus according to the present invention exhibits such an advantageous effect that a higher frequency component of the band-extended signal sounds not artificial but natural relative to the original sound.

In addition, the bandpass filtering processing, the level correlated white noise generating processing, and the signal processing are executed by digital signal processing as shown in Fig. 2. Accordingly, variations in performance do not occur due to variations in components that constitute circuits, and temperature characteristic. In addition, deterioration in sound quality does not occur when the audio signal passes through each of the circuits. Further, even if the accuracy of each filter that constitutes the same circuit is improved, size of circuits is not made large and manufacturing cost is not increased, in a manner different from that of an apparatus constituted by analog circuits.

Further, before the bandpass filtering processing and the final adding processing are executed, the oversampling processing and the low-pass filtering processing are executed as shown in Fig. 3. Accordingly, a lower-order analog low-pass filter can be provided at the previous stage of the A/D converter, and this leads to extremely large reduction in the phase distortion and the noise accompanied by the filtering processing. In addition, the quantized noise can be reduced, and conversion at a low quantization bit rate can be easily performed. Further, a higher-order higher harmonic wave component of the inputted signal X can be generated in advance and used, and therefore the higher-order higher harmonic wave component can be easily generated.

Still further, the oversampling processing is inserted between the level correlated white noise generating processing and the signal processing, and executed as shown in Fig. 4. In addition, before the final adding processing is executed, the oversampling processing and the low-pass filtering processing are executed on the inputted signal. Accordingly, it is possible to set a signal rate to a higher signal rate in the circuits provided at the subsequent stage of the oversampling type low-pass filter and the oversampling circuit. In other words, it is possible to set signal rates of circuits provided at the previous stage of the oversampling type low-pass filter and the oversampling circuit to lower signal rates, and this leads to simplification of the circuit configuration.

FIFTH PREFERRED EMBODIMENT

Fig. 34 is a block diagram showing a configuration of an optical disk reproduction system 500, which is one example of an application of the audio signal band extending apparatus, according to a fifth preferred embodiment of the present invention.

In the first to fourth preferred embodiments described above, the audio signal band extending apparatuses 100-1 to 100-4 are constituted by hardware or the digital signal processing circuit. However, the present invention is not limited to this. For example, each of processing steps in the configuration of the audio signal band extending apparatuses 100-1 to 100-4 shown in Figs. 1 to 4 may be realized by a signal processing program for extending a band of an audio signal. In addition, the signal processing program may be stored in a program memory 501p of a DSP 501 shown in Fig. 34 and executed by the DSP 501. It is noted that a data table memory 501d of the DSP 501 stores various kinds of data necessary to execute the signal processing program.

Referring to Fig. 34, an optical disk reproducer apparatus 502 is an apparatus for reproducing a content of an optical disk, for example, a DVD player, a CD player, or an MD player. The DSP 501 executes the signal processing program for left and right digital audio signals reproduced by the optical disk reproducer apparatus 502, and audio digital signals which are band-extended from an inputted audio digital signals are obtained and outputted to a D/A converter 503. Next, the D/A converter 503 converts an inputted digital audio signals into analog audio signals, and outputs the analog audio signals to left and right loudspeakers 505a and 505b via power amplifiers 504a and 504b, respectively. In this case, a system controller 500 controls an overall operation of the optical disk reproduction system and particularly controls operations of the optical disk reproducer apparatus 502 and the DSP 501. In addition, the program memory 501p and the data table memory 501d of the DSP 501 are constituted by nonvolatile memories such as flash memories or EEPROMs.

In the optical disk system constituted as described so far, digital audio signals reproduced by the optical disk reproducer apparatus 502 can be appropriately band-extended by the DSP 501 and then reproduced by the left and right loudspeakers 505a and 505b, respectively.

As described so far, according to the fifth preferred embodiment, the respective processing steps in the configuration of the audio signal band extending apparatuses 100-1 to 100-4 shown in Figs. 1 to 4 are realized by the signal processing program for extending the band of the audio signal, and the signal processing program is executed by the DSP 501 shown in Fig. 34. Accordingly, it is possible to easily upgrade versions for adding functions of the signal processing program and for debugging.

In the fifth preferred embodiment, the signal processing program and data for executing the program may be stored in the program memory 501p and the data table memory 501d, respectively, in advance during a manufacturing process. Alternatively, as shown below, the signal processing program and the data for executing the program which are recorded in a computer readable recording medium such as a CD-ROM 511 may be reproduced by an optical disk drive 510 including a controller such as a computer or the like, and the reproduced program and data may be stored in the program memory 501p and the data table memory 501d within the DSP 501, respectively, via an external interface 506.

In the present preferred embodiment, the DSP 501 is employed. However, the present invention is not limited to this, and a controller for a digital calculator such as a micro processor unit (MPU) may be employed.

INDUSTRIAL APPLICABILITY

As stated above in detail, according to the audio signal band extending apparatus according to the present invention, there is generated a noise signal having a level changing according to a level of an inputted signal and correlated to the level of the inputted signal in bands equal to or higher than the band of the inputted signal, and the noise signal is added to the inputted signal so as to keep the spectral continuity thereof. Accordingly, it is possible to easily generate a signal having an extended audio band as compared with the prior art. In addition, a band-extended signal obtained as stated above changes according to a level of an original sound and keeps its spectral continuity. Accordingly, the apparatus according to the present invention exhibits such an advantageous effect that a higher frequency component of the band-extended signal sounds not artificial but natural relative to the original sound.

In addition, according to the audio signal band extending apparatus according to the present invention, the bandpass filtering processing, the level correlated white noise generating processing, and the signal processing are executed by digital signal processing. Accordingly, variations in performance do not occur due to variations in components that constitute circuits, and temperature characteristic. In addition, deterioration in sound quality does not occur when the audio signal passes through each of the circuits. Further, even if the accuracy of each filter that constitutes the same circuit is improved, size of circuits is not made large and manufacturing cost is not increased, in a manner different from that of an apparatus constituted by analog circuits.

Further, according to the audio signal band extending apparatus according to the present invention, before the bandpass filtering processing and the final adding processing are executed, the oversampling processing and a low-pass filtering processing are executed. Accordingly, the lower-order analog low-pass filter can be provided at the previous stage of the A/D converter, and this leads to extremely large reduction in the phase distortion and the noise accompanied by the filtering processing. In addition, the quantized noise can be reduced, and conversion at a low quantization bit rate can be easily performed. Further, a higher-order higher harmonic wave component of the inputted signal X can be generated in advance and used, and therefore a higher-order higher harmonic wave component can be easily generated.

Still further, according to the audio signal band extending apparatus according to the present invention, the oversampling processing is inserted between the level correlated white noise generating processing and the signal processing, and executed. In addition, before the final adding processing is executed, the oversampling processing and the low-pass filtering processing are executed on the inputted signal. Accordingly, it is possible to set a signal rate to a higher signal rate in the circuits provided at the subsequent stage of the oversampling type low-pass filter and the oversampling circuit. In other words, it is possible to set signal rates of circuits provided at the previous stage of the oversampling type low-pass filter and the oversampling circuit to lower signal rates, and this leads to simplification of the circuit configuration.

In addition, the optical disk system according to the present invention can reproduce an audio signal stored in an optical disk, extends a band of a reproduced audio signal, and output a band-extended audio signal. Accordingly, it is possible to easily generate a signal having an extended audio band based on the audio signal stored in the optical disk as compared with the prior.

**Claims**

1. An audio signal band extending apparatus (100) comprising:

noise generating means (300) for generating a noise signal level-correlated to and so as to change according to one of a level of an inputted signal (101) or a level of a signal in a partial band obtained by bandpass-filtering the inputted signal (101) using bandpass filtering means (200);
signal processing means (400) for multiplying the generated noise signal by a predetermined transfer function so that, at a lower limit frequency of a predetermined frequency band corresponding to the extended band, a level of the generated noise signal substantially coincides with the level of the inputted signal (101) and a spectral continuity thereof is kept when addition is executed by adding means (800), and for outputting a signal having a multiplication result; and
adding means (800) for adding up the inputted signal (101) and the outputted signal from said signal processing means (400), and for outputting a signal (102) having an addition result,

wherein said noise generating means (300) comprises:

level signal generating means (310) for detecting a level of the signal inputted to said noise generating means (300), and for generating and outputting a level signal having the detected level;
white noise signal generating means (320) for generating and outputting a white noise signal including a quantization noise, the quantization noise being by cutting out at least one of predetermined intermediate lower-order or predetermined lower-order set of bits from the signal (301) inputted to said noise signal generating means (300); and

multiplying means (340) for multiplying the level signal from said level signal generating means (310) by the white noise signal from said white noise signal generating means (320), and for outputting a noise signal having a multiplication result.

2. The audio signal band extending apparatus (100) as claimed in claim 1,

wherein said level signal generating means (310) cuts out predetermined higher-order set of bits from the signal inputted to said noise generating means (300), and outputs the level signal including the higher-order set of bits, and wherein said white noise signal generating means (320) cuts out at least one of predetermined intermediate-order set of bits and predetermined lower-order set of bits from the signal inputted to said noise generating means (300), and outputs the white noise signal including the at least one of the predetermined intermediate-order set of bits and predetermined lower-order set of bits.

3. An audio signal band extending apparatus (100) comprising:

noise generating means (300) for generating a noise signal level-correlated to and so as to change according to one of a level of an inputted signal (101) or a level of a signal in a partial band obtained by bandpass-filtering the inputted signal (101) using bandpass filtering means (200);

signal processing means (400) for multiplying the generated noise signal by a predetermined transfer function so that, at a lower limit frequency of a predetermined frequency band corresponding to the extended band, a level of the generated noise signal substantially coincides with the level of the inputted signal (101) and a spectral continuity thereof is kept when addition is executed by adding means (800), and for outputting a signal having a multiplication result; and

adding means (800) for adding up the inputted signal (101) and the outputted signal (102) from said signal processing means (400), and for outputting a signal having an addition result,

wherein said noise generating means (300) comprises:

non-uniformity quantization means (351) for quantizing the signal inputted to said noise generating means (300) non-uniformly relative to a level thereof, and for outputting a resultant signal;

dequantization means (361) for executing a processing opposite to a processing executed by said non-uniformity quantization means (351) on the signal from said non-uniformity quantization means (351), and for outputting a resultant signal; and

subtraction means (371) for generating and outputting a quantized noise signal (302) of the signal inputted to said noise generating means (300) by calculating the difference between the signal inputted to said noise generating means (300) and the signal from said dequantization means (361).

4. The audio signal band extending apparatus (100) as claimed in any one of claims 1 to 3, further comprising:

first conversion means (130) provided so as to be inserted at the previous stage of said bandpass filtering means (200), said first conversion means (130) converting the inputted signal (101) into a digital signal; and second conversion means (131) provided so as to be inserted between said signal processing means (400) and said adding means (800), said second conversion means (131) converting the outputted signal (102) from said signal processing means (400) into an analog signal.

5. The audio signal band extending apparatus (100) as claimed in any one of claims 1 to 3, further comprising:

oversampling type low-pass filtering means (120) provided so as to be inserted at the previous stage of said bandpass filtering means (200) and said adding means (800), said oversampling type low-pass filtering means (120) oversampling and low-pass filtering the inputted signal (101), and outputting a resultant signal to said bandpass filtering means (200) and said adding means (800).

6. The audio signal band extending apparatus (100) as claimed in any one of claims 1 to 3, further comprising:

oversampling type low-pass filtering means (120) provided to be inserted at the previous stage of said adding means (800), said oversampling type low-pass filtering means (120) oversampling and low-pass filtering the inputted signal (101), and outputting a resultant signal to said adding means (800); and
oversampling means (121) provided to be inserted between said noise generating means (300) and said signal processing means (400), said oversampling means (121) oversampling the noise signal from said noise generating means (300), and outputting a resultant signal to said signal processing means (400).

**7.** The audio signal band extending apparatus (100) as claimed in claim 1,
wherein said white noise signal generating means (320) comprises a delta sigma modulator type quantizer (20), generates a quantized noise signal (303) of a signal inputted to said white noise signal generating means (320), and outputs a generated quantized noise signal (303) as the white noise signal.

**8.** The audio signal band extending apparatus (100) as claimed in claim 2,
wherein said second cutting-out means cuts out either one of a combination of intermediate-order set of bits and lower-order set of bits, and two lower-order set of bits, at different bit locations and with a predetermined bit width, adding up cut out bits, and outputs a signal having an addition result.

**9.** The audio signal band extending apparatus (100) as claimed in claim 2,
wherein said second cutting-out means cuts out either one of a combination of intermediate-order set of bits and two lower-order set of bits, and three lower-order set of bits, at different bit locations and with a predetermined bit width, adding up cut out bits, and outputs a signal having an addition result.

**10.** The audio signal band extending apparatus (100) as claimed in claim 2, further comprising:

independent noise generating means (300) for generating a noise signal independent of the inputted signal (101); and

further adding means (800) for adding up the noise signal from said second cutting-out means and the noise signal from said independent noise generating means (300), and for outputting a signal having an addition result to said multiplying means (340).

**11.** The audio signal band extending apparatus (100) as claimed in claim 10,
wherein said independent noise generating means (300) generates a plurality of noise signals different from each other, adds up said plurality of noise signals, and outputs a signal having an addition result.

**12.** The audio signal band extending apparatus (100) as claimed in claim 10 or 11,
wherein said independent noise generating means (300) generates a diamond dithering noise signal.

**13.** The audio signal band extending apparatus (100) as claimed in claim 3,
wherein said non-uniformity quantization means (351) quantizes an inputted signal (101) so as to increase a quantization width as a level of the inputted signal (101) is larger.

**14.** The audio signal band extending apparatus (100) as claimed in claim 3 or 13,
wherein said non-uniformity quantization means (351) compresses a run length of a linear code of L bits into 1/N thereof so as to generate and output data of M bits, where L, M and N are positive integers each of which equals to or larger than 2.

**15.** The audio signal band extending apparatus (100) as claimed in any one of claims 3, 13 and 14,
wherein said non-uniformity quantization means (351) converts a linear code of L bits that consists of continuous data Q0 of continuous bits each having a predetermined logic and being allocated in a higher order part, an inverted bit T0 that breaks continuity of the continuous data Q0, and lower-order data D0 following the inverted bit T0 into compressed data of M bits consisting of compressed continuous data Q1 obtained by compressing a run length of the continuous data Q0, an inverted bit T1 for that breaks continuity of the compressed continuous data Q1, compressed residual data F1 representing a residue generated upon compressing the run length, and mantissa data D1 obtained by rounding the lower-order data D0 and outputs the compressed data of M bits, and
wherein, provided that the run length of the continuous data Q0 is L0, a run length of the compressed continuous data Q1 is L1, and that N is an integer equal to or larger than 2, the run length L1 of the compressed continuous data Q1 and the compressed residual data F1 are expressed by $L1 = Int\ (L0/N)$ and $F1 = L0\ mod\ N$, respectively, where Int is a function that represents an integer value of an argument, and A mod B is a function that represents a residue obtained when A is divided by B.

**16.** The audio signal band extending apparatus (100) as claimed in any one of claims 3, 13 and 14,
wherein said dequantization means (361) extends a compressed data that consists of compressed continuous data Q1 of continuous bits each having a predetermined logic and being allocated in a higher-order part, an inverted bit T1 that breaks continuity of the compressed continuous data Q1, compressed residual data F1 representing a residue generated upon compressing a run length of the compressed continuous data Q1, and a mantissa data D1, by extending the run length of the compressed continuous data Q1 by "N" times, adding continuous data having a length corresponding to a value of the F1, adding an inverted bit T0 that breaks continuity of Q0, further adding the mantissa data D1 to a resultant data, reading out the continuous data Q0, the inverted bit T0 and the mantissa data D0, and outputting an extended data, and
wherein, provided that a run length of the continuous data Q0 is L0, a run length of said compressed continuous data Q1 is L1, a residue obtained from the compressed residual data F1 is F 1, and N is an integer equal to or larger than 2, the run length L0 and the mantissa data D0 are expressed by $L0 = L1*n+F1$ and $D0 = D1$, respectively, where $*$ is an arithmetic symbol representing multiplication.

**17.** The audio signal band extending apparatus (100) as claimed in any one of claims 3 and 13 to 16,
wherein said non-uniformity quantization means (351) floating-encodes an inputted linear code into a floating code having a predetermined effective bit length, and outputs an encoded signal having the floating code.

**18.** The audio signal band extending apparatus (100) as claimed in any one of claims 1 to 17,
wherein said noise generating means (300) comprises:

> table memory means for storing a relationship between the signal inputted to said noise generating means (300) and a noise signal level-correlated to the signal inputted to said noise generating means (300) so as to change according to a level of the signal inputted to said noise generating means (300); and
> conversion means for, responsive to the signal inputted to said noise generating means (300), reading out and outputting a noise signal corresponding to the signal inputted to said noise generating means (300) from said table memory means.

**19.** The audio signal band extending apparatus (100) as claimed in any one of claims 1 to 18,
wherein said signal processing means (400) comprises at least first filtering means, and
wherein said signal processing means (400) filters out frequency bands higher than a frequency band of the inputted signal (101).

**20.** The audio signal band extending apparatus (100) as claimed in any one of claims 1 to 19,
wherein said signal processing means (400) comprises at least (1/f) filtering means, and
wherein said signal processing means (400) applies a (1/f) reduction characteristic to a higher frequency band spectrum of the signal inputted to said signal processing means (400).

**21.** The audio signal band extending apparatus (100) as claimed in any one of claims 1 to 20,
wherein said signal processing means (400) comprises at least echo adding processing means, and
wherein said signal processing means (400) adds an echo signal to a higher frequency band spectrum of the signal inputted to said signal processing means (400).

**22.** The audio signal band extending apparatus (100) as claimed in any one of claims 1 to 21,
wherein said signal processing means (400) comprises at least second filtering means, and
wherein said signal processing means (400) filters out frequency bands higher than a frequency band of the signal inputted to said signal processing means (400) so as to include frequency bands exceeding a Nyquist frequency.

**Patentansprüche**

**1.** Audiosignalbandexpansionsvorrichtung (100) mit:

> einem Rauscherzeugungsmittel (300) zum Erzeugen eines Rauschsignals, das zu einem Niveau eines eingegebenen Signals (101) oder zu einem Niveau eines Signals in einem Teilband, das durch Bandpass-Filtern des eingegebenen Signals (101) unter Verwendung von Bandpassfiltermitteln (200) erhalten wurde, niveau-korreliert ist und sich entsprechend dazu ändert,
> einem Signalverarbeitungsmittel (400) zum Multiplizieren des erzeugten Rauschsignals mit einer vorbestimmten Transferfunktion derart, dass an einer unteren Grenzfrequenz eines vorbestimmten Frequenzbandes entsprechend des ausgedehnten Bandes ein Niveau des erzeugten Rauschsignals im wesentlichen mit dem Niveau des eingegebenen Signals (101) zusammenfällt und eine spektrale Kontinuität davon beibehalten wird, wenn eine Addition durch ein Addiermittel (800) ausgeführt wird, und zum Ausgeben eines Signals mit einem Multiplikationsergebnis, und

einem Addiermittel (800) zum Aufaddieren des eingegebenen Signals (101) und des ausgegebenen Signals aus dem Signalverarbeitungsmittel (400) und zum Ausgeben eines Signals (102) mit einem Additionsergebnis,

wobei das Rauscherzeugungsmittel (300) umfasst:

ein Niveausignalerzeugungsmittel (310) zum Erfassen eines Niveaus des Signals, das in das Rauscherzeugungsmittel (300) eingegeben wurde, und zum Erzeugen und Ausgeben eines Niveausignals mit dem erfassten Niveau,

ein Erzeugungsmittel (320) für ein weißes Rauschsignal zum Erzeugen und Ausgeben eines weißen Rauschsignals mit einem Quantisierungsrauschen, wobei das Quantisierungsrauschen durch Ausschneiden eines vorbestimmten Satzes von Bits mittlerer Ordnung und/oder eines vorbestimmten Satzes von Bits niederer Ordnung aus dem Signal (301) erhalten wird, das in das Rauschsignalerzeugungsmittel (300) eingegeben wurde, und

ein Multipliziermittel (340) zum Multiplizieren des Niveausignals aus dem Niveausignalerzeugungsmittel (310) mit dem weißen Rauschsignal aus dem Erzeugungsmittel (320) für ein weißes Rauschsignal und zum Ausgeben eines Rauschsignals mit einem Multiplikationsergebnis.

**2.** Audiosignalbandexpansionsvorrichtung (100) nach Anspruch 1,
wobei das Niveausignalerzeugungsmittel (310) einen vorbestimmten Satz von Bits höherer Ordnung aus dem Signal ausschneidet, das in das Rauscherzeugungsmittel (300) eingegeben wurde, und das Niveausignal mit dem Satz von Bits höherer Ordnung ausgibt, und
wobei das Erzeugungsmittel (320) für ein weißes Rauschsignal einen vorbestimmten Satz von Bits mittlerer Ordnung und/oder einen vorbestimmten Satz von Bits niederer Ordnung aus dem Signal ausschneidet, das in das Rauscherzeugungsmittel (300) eingegeben wurde, und das weiße Rauschsignal mit dem vorbestimmten Satz Bits mittlerer Ordnung und/oder dem vorbestimmten Satz Bits niederer Ordnung ausgibt.

**3.** Audiosignalbandexpansionsvorrichtung (100) mit:

einem Rauscherzeugungsmittel (300) zum Erzeugen eines Rauschsignals, das zu einem Niveau eines eingegebenen Signals (100) oder zu einem Niveau eines Signals in einem Teilband, das durch Bandpass-Filtern des eingegebenen Signals (101) unter Verwendung von Bandpassfiltermitteln (200) erhalten wurde, niveau-korreliert ist und sich entsprechend dazu ändert,

einem Signalverarbeitungsmittel (400) zum Multiplizieren des erzeugten Rauschsignals mit einer vorbestimmten Transferfunktion derart, dass an einer unteren Grenzfrequenz eines vorbestimmten Frequenzbandes entsprechend des ausgedehnten Bandes ein Niveau des erzeugten Rauschsignals im wesentlichen mit dem Niveau des eingegebenen Signals (101) zusammenfällt und eine spektrale Kontinuität davon beibehalten wird, wenn einen Addition durch ein Addiermittel (800) durchgeführt wird, und zum Ausgeben eines Signals mit einem Multiplikationsergebnis, und

einem Addiermittel (800) zum Aufaddieren des eingegebenen Signals (101) und des ausgegebenen Signals (102) aus dem Signalverarbeitungsmittel (400) und zum Ausgeben eines Signals mit einem Additionsergebnis,

wobei das Rauscherzeugungsmittel (300) umfasst:

ein Nicht-Uniformitätsquailtisierungsmittel (351) zum Quantisieren des Signals, das in das Rauscherzeugungsmittel (300) eingegeben wurde, in nichtuniformer Weise relativ zu einem Niveau davon und zum Ausgeben eines resultierenden Signals,

ein Dequantisierungsmittel (361) zum Ausführen einer Verarbeitung entgegengesetzt einer Verarbeitung, die durch das Nicht-Uniformitätsquantisierungsmittel (351) durchgeführt wurde, an dem Signal aus dem Nicht-Uniformitätsquantisierungsmittel (351) und zum Ausgeben eines resultierenden Signals, und

ein Substraktionsmittel (371) zum Erzeugen und Ausgeben eines quantisierten Rauschsignals (302) des Signals, das in das Rauscherzeugungsmittel (300) eingegeben wurde, durch Berechnen der Differenz zwischen dem Signal, das in das Rauscherzeugungsmittel (300) eingegeben wurde, und dem Signal von dem Dequantisierungsmittel (361).

**4.** Audiosignalbandexpansionsvorrichtung (100) nach einem der Ansprüche 1 bis 3, ferner mit:

einem ersten Konversionsmittel (130), das vorgesehen ist, um an der Stufe vor dem Bandpass-Filtermittel (200) eingefügt zu werden, wobei das erste Konversionsmittel (130) das eingegebene Signal (101) in ein digitales Signal konvertiert, und
ein zweites Konversionsmittel (131), das vorgesehen ist, um zwischen dem Signalverarbeitungsmittel (400) und dem Addiermittel (800) eingefügt zu werden,

wobei das zweite Konversionsmittel (131) das ausgegebene Signal (102) aus dem Signalverarbeitungsmittel (400) in ein analoges Signal umwandelt.

**5.** Audiosignalbandexpansionsvorrichtung (100) nach einem der Ansprüche 1 bis 3, ferner mit:

einem Tiefpass-Filtermittel (120) des Überabtastungstyps, das vorgesehen ist, an der Stufe vor dem Bandpass-Filtermittel (200) und dem Addiermittel (800) eingefügt zu werden, wobei das Tiefpass-Filtermittel (120) des Überabtastungstyps das eingegebene Signal (101) überabtastet und tiefpass-filtert und ein resultierendes Signal an das Bandpass-Filtermittel (200) und das Addiermittel (800) ausgibt.

**6.** Audiosignalbandexpansionsvorrichtung (100) nach einem der Ansprüche 1 bis 3, ferner mit:

einem Tiefpass-Filtermittel (120) des Überabtastungstyps, das vorgesehen ist, an der Stufe vor dem Addiermittel (800) eingefügt zu werden, wobei das Tiefpass-Filtermittel (120) des Überabtastungstyps das eingegebene Signal (101) überabtastet und tiefpass-filtert und ein resultierendes Signal an das Addiermittel (800) ausgibt, und
ein Überabtastungsmittel (121), das vorgesehen ist, zwischen dem Rauscherzeugungsmittel (300) und dem Signalverarbeitungsmittel (400) eingefügt zu werden, wobei das Überabtastungsmittel (121) das Rauschsignal aus dem Rauscherzeugungsmittel (300) überabtastet und ein resultierendes Signal an das Signalverarbeitungsmittel (400) ausgibt.

**7.** Audiosignalbandexpansionsvorrichtung (100) nach Anspruch 1,
wobei das Erzeugungsmittel (320) für ein weißes Rauschsignal einen Quantisierer (20) des Delta-Sigma-Modulator-Typs aufweist, ein quantisiertes Rauschsignal (303) eines Signals erzeugt, das in das Erzeugungsmittel (320) für ein weißes Rauschsignal eingegeben wurde, und ein erzeugtes quantisiertes Rauschsignal (303) als das weiße Rauschsignal ausgibt.

**8.** Audiosignalbandexpansionsvorrichtung (100) nach Anspruch 2,
wobei das zweite Ausschneidemittel entweder eine Kombination von einem Satz von Bits mittlerer Ordnung und einem Satz von Bits niederer Ordnung oder zwei Sätze von Bits niederer Ordnung zu verschiedenen Bitpositionen und mit einer vorbestimmten Bitbreite ausschneidet, ausgeschnittene Bits aufaddiert und ein Signal mit einem Additionsergebnis ausgibt.

**9.** Audiosignalbandexpansionsvorrichtung (100) nach Anspruch 2,
wobei das zweite Ausschneidemittel entweder eine Kombination von einem Satz von Bits mittlerer Ordnung und zwei Sätzen von Bits niederer Ordnung oder drei Sätze von Bits niederer Ordnung zu verschiedenen Bitpositionen und mit einer vorbestimmten Bitbreite ausschneidet, ausgeschnittene Bits aufaddiert und ein Signal mit einem Additionsergebnis ausgibt.

**10.** Audiosignalbandexpansionsvorrichtung (100) nach Anspruch 2, ferner mit:

einem unabhängigen Rauscherzeugungsmittel (300) zum Erzeugen eines Rauschsignals unabhängig von dem eingegebenen Signal (101), und
einem weiteren Addiermittel (800) zum Aufaddieren des Rauschsignals von dem zweiten Ausschneidemittel und des Rauschsignals von dem unabhängigen Rauscherzeugungsmittel (300) und zum Ausgeben eines Signals mit einem Additionsergebnis an das Multipliziermittel (340).

**11.** Audiosignalbandexpansionsvorrichtung (100) nach Anspruch 10,
wobei das unabhängige Rauscherzeugungsmittel (300) mehrere voneinander unterschiedliche Rauschsignale erzeugt, die mehrere Rauschsignale aufaddiert und ein Signal mit einem Additionsergebnis ausgibt.

**12.** Audiosignalbandexpansionsvorrichtung (100) nach Anspruch 10 oder 11,
wobei das unabhängige Rauscherzeugungsmittel (300) ein Diamant-Dithering-Rauschsignal erzeugt.

**13.** Audiosignalbandexpansionsvorrichtung (100) nach Anspruch 3,
wobei das Nicht-Uniformitätsquantisierungsmittel (351) ein eingegebenes Signal (101) derart quantisiert, dass eine Quantisierungsbreite erhöht wird, so dass ein Niveau des eingegebenen Signals (101) größer wird.

**14.** Audiosignalbandexpansionsvorrichtung (100) nach Anspruch 3 oder 13,
wobei das Nicht-Uniformitätsquantisierungsmittel (351) eine Lauflänge eines linearen Kodes von L Bits in 1/N davon komprimiert, derart, dass Daten von M Bits erzeugt und ausgegeben werden, wobei L, M und N positive ganze Zahlen sind, die jeweils größer oder gleich 2 sind.

**15.** Audiosignalbandexpansionsvorrichtung (100) nach einem der Ansprüche 3, 13 oder 14,
wobei das Nicht-Uniformitätsquantisierungsmittel (351) einen linearen Kode von L Bits, das aus kontinuierlichen Daten Q0 von kontinuierlichen Bits, die jeweils eine vorbestimmte Logik besitzen und in einem Teil höherer Ordnung angeordnet sind, einem invertierten Bit T0, das eine Kontinuität der kontinuierlichen Daten Q0 unterbricht, und Daten D0 niederer Ordnung, die dem invertierten Bit T0 folgen, zu komprimierten Daten von M Bits konvertiert, die aus komprimierten kontinuierlichen Daten Q1, die durch Komprimieren einer Lauflänge der kontinuierlichen Daten Q0 erhalten wurden, einem invertierten Bit T1, das die Kontinuität der komprimierten kontinuierlichen Daten Q1 unterbricht, komprimierten Restdaten F1, die einen Restwert darstellen, der beim Komprimierten der Lauflänge erzeugt wurde, und Mantissendaten D1 bestehen, die durch Runden der Daten D0 niederer Ordnung erhalten wurden, und die komprimierten Daten von M Bits ausgibt, und
wobei, in dem Fall, dass die Lauflänge der kontinuierlichen Daten Q0 L0 ist, eine Lauflänge der komprimierten kontinuierlichen Daten Q1 L1 ist, und dass N eine ganze Zahl gleich oder größer als 2 ist, die Lauflänge L1 der komprimierten kontinuierlichen Daten Q1 und der komprimierten Restdaten F1 jeweils durch L=Int (L0/N) und F1=L0 mod N dargestellt werden, wobei InT eine Funktion ist, die einen ganzzahligen Wert eines Arguments wiedergibt, und A mod B eine Funktion ist, die einen Restwert wiedergibt, der erhalten wird, wenn A durch B geteilt wird.

**16.** Audiosignalbandexpansionsvorrichtung (100) nach einem der Ansprüche 3, 13 oder 14,
wobei das Dequantisierungsmittel (361) komprimierte Daten ausdehnt, die aus komprimierten kontinuierlichen Daten Q1 von kontinuierlichen Bits, die jeweils eine vorbestimmte Logik besitzen und in einem Teil höherer Ordnung angeordnet sind, einem invertierten Bit T1, das die Kontinuität der komprimierten kontinuierlichen Daten Q1 unterbricht, komprimierten Restdaten F1, die einen Restwert darstellen, der beim Komprimieren einer Lauflänge der komprimierten kontinuierlichen Daten Q1 erzeugt wurde, und einem Mantissendatum D1 bestehen, durch Ausdehnen der Lauflänge der komprimierten kontinuierlichen Daten Q1 "N"-mal, Addieren von kontinuierlichen Daten mit einer Länge entsprechend einem Wert des F1, Addieren mit einem invertierten Bit T0, das die Kontinuität von Q0 unterbricht, weiterem Addieren des Mantissendatums D1 zu einem resultierenden Datum, Auslesen der kontinuierlichen Daten Q0, des invertierten Bits T0 und des Mantissendatums D0, und Ausgeben von ausgedehnten Daten, und
wobei, in dem Fall, dass eine Lauflänge der kontinuierlichen Daten Q0 L0 ist, eine Lauflänge der komprimierten kontinuierlichen Daten Q1 L1 ist, ein Restwert, der von den komprimierten Restdaten F1 erhalten wird. F1 ist, und N eine ganze Zahl ist, die größer oder gleich 2 ist, die Lauflänge L0 und das Mantissendatum D0 jeweils durch L0 = L1*n+F1 und D0 = D1 ausgedrückt werden, wobei * ein arithmetisches Symbol ist, das für eine Multiplikation steht.

**17.** Audiosignalbandexpansionsvorrichtung (100) nach einem der Ansprüche 3 oder 13 bis 16,
wobei das Nicht-Uniformitätsquantisierungsmittel (351) einen eingegebenen linearen Kode in einen Fließ-Kode mit einer vorbestimmten effektiven Bitlänge fließkodiert und ein kodiertes Signal mit dem Fließ-Kode ausgibt.

**18.** Audiosignalbandexpansionsvorrichtung (100) nach einem der Ansprüche 1 bis 17,
wobei das Rauscherzeugungsmittel (300) umfasst:

ein Tabellenspeichermittel zum Speichern einer Beziehung zwischen dem Signal, das in das Rauscherzeugungsmittel (300) eingegeben wurde, und einem Rauschsignal, das zu dem Signal niveau-korreliert ist, das in das Rauscherzeugungsmittel (300) eingegeben wurde, um gemäß einem Niveau des Signals geändert zu werden, das in das Rauscherzeugungsmittel (300) eingegeben wurde, und

ein Konversionsmittel zum Auslesen und Ausgeben eines Rauschsignals, in Antwort auf das Signal, das in das Rauscherzeugungsmittel (300) eingegeben wurde, das dem Signal entspricht, das in das Rauscherzeugungsmittel (300) eingebeben wurde, aus dem Tabellenspeichermittel.

**19.** Audiosignalbandexpansionsvorrichtung (100) nach einem der Ansprüche 1 bis 18,
wobei das Signalverarbeitungsmittel (400) wenigstens ein erstes Filtermittel aufweist, und
wobei das Signalverarbeitungsmittel (400) Frequenzbänder oberhalb eines Frequenzbandes des eingegebenen Signals (101) ausfiltert.

**20.** Audiosignalbandexpansionsvorrichtung (100) nach einem der Ansprüche 1 bis 19,
wobei das Signalverarbeitungsmittel (400) wenigstens ein (1/f)-Filtermittel aufweist, und
wobei das Signalverarbeitungsmittel (400) eine (1/f)-Reduktions-charakteristik auf ein höheres Frequenzbandspektrum des Signals anwendet, das in das Signalverarbeitungsmittel (400) eingegeben wurde.

**21.** Audiosignalbandexpansionsvorrichtung (100) nach einem der Ansprüche 1 bis 20,
wobei das Signalverarbeitungsmittel (400) wenigstens ein Echoaddierverarbeitungsmittel aufweist, und
wobei das Signalverarbeitungsmittel (400) ein Echosignal zu einem Höherfrequenzbandspektrum des Signals addiert, das in das Signalverarbeitungsmittel (400) eingegeben wurde.

**22.** Audiosignalbandexpansionsvorrichtung (100) nach einem der Ansprüche 1 bis 21,
wobei das Signalverarbeitungsmittel (400) wenigstens ein zweites Filtermittel aufweist, und
wobei das Signalverarbeitungsmittel (400) Frequenzbänder oberhalb eines Frequenzbandes des Signals ausfiltert, das in das Signalverarbeitungsmittel (400) eingegeben wurde, um Frequenzbänder jenseits einer Nyquist-Frequenz einzuschließen.


**Revendications**

**1.** Appareil (100) d'extension de bandes de signaux audio comprenait:

un moyen (300) de génération de bruit pour générer un signal de bruit corrélé au niveau et de manière à changer selon l'un d'un niveau d'un signal introduit (101) ou d'un niveau d'un signal dans une bande partielle obtenue par un filtrage passe-bande du signal introduit (101) en utilisant un moyen (200) de filtrage passe-bande;
un moyen (400) de traitement de signaux pour multiplier le signal de bruit généré par une fonction de transfert prédéterminée de sorte que, à une fréquence limite inférieure d'une bande de fréquences prédéterminée correspondant à la bande étendue, un niveau du signal de bruit généré coïncide essentiellement avec le niveau du signal introduit (101) et une continuité spectrale correspondante est gardée lorsqu'une addition est exécutée par un moyen d'addition (800), et pour délivrer en sortie un signal ayant un résultat de multiplication; et
un moyen d'addition (800) pour additionner le signal introduit (101) et le signal délivré en sortie dudit moyen (400) de traitement de signaux, et pour délivrer en sortie un signal (102) ayant un résultat d'addition,

où ledit moyen (300) de génération de bruit comprend:

un moyen (310) de génération de signaux de niveau pour détecter un niveau du signal introduit audit moyen (300) de génération de bruit, et pour générer et délivrer en sortie un signal de niveau ayant le niveau détecté;
un moyen (320) de génération de signaux de bruit blanc pour générer et délivrer en sortie un signal de bruit blanc incluant un bruit de quantification, le bruit de quantification étant obtenu en coupant au moins un ordre parmi un ensemble de bits d'ordre intermédiaire prédéterminé ou d'ordre inférieur prédéterminé du signal (301) introduit audit moyen (300) de génération de signaux de bruit; et
un moyen (340) de multiplication pour multiplier le signal de niveau provenant dudit moyen (310) de génération de signaux de niveau par le signal de bruit blanc provenant dudit moyen (320) de génération de signaux de bruit blanc, et pour délivrer en sortie un signal de bruit ayant un résultat de multiplication.

**2.** Appareil (100) d'extension de bandes de signaux audio selon la revendication 1,
dans lequel ledit moyen (310) de génération de signaux de niveau coupe un ensemble de bits d'ordre supérieur prédéterminé du signal introduit audit moyen (300) de génération de bruit, et délivre en sortie le signal de niveau incluant l'ensem6le de bits d'ordre supérieur, et
où ledit moyen (320) de génération de signaux de bruit blanc coupe au moins l'un parmi un ensemble de bits d'ordre intermédiaire prédéterminé et un ensemble de bits d'ordre inférieur prédéterminé du signal introduit audit moyen (300) de génération de bruit, et délivre en sortie le signal de bruit blanc incluant le au moins un parmi l'ensemble de bits d'ordre intermédiaire prédéterminé et l'ensemble de bits d'ordre inférieur prédéterminé.

3. Appareil (100) d'extension de bandes de signaux audio comprenant:

un moyen (300) de génération de bruit pour générer signal de bruit corrélé au niveau et de manière à changer selon l'un d'un niveau d'un signal introduit (101) ou d'un niveau d'un signal dans une bande partielle obtenue par un filtrage passe-bande du signal introduit (101) en utilisant un moyen (200) de filtrage passe-bande;
un moyen (400) de traitement de signaux pour multiplier le signal de bruit généré par une fonction de transfert prédéterminée de sorte que, à une fréquence limite inférieure d'une bande de fréquences prédéterminée correspondant à la bande étendue, un niveau du signal de bruit généré coïncide essentiellement avec le niveau du signal introduit (101) et une continuité spectrale correspondante est gardée lorsqu'un addition est exécuté par un moyen d'addition (800), et pour délivrer en sortie un signal ayant un résultat de multiplication; et
un moyen d'addition (800) pour additionner le signal introduit (101) et le signal délivré en sortie (102) dudit moyen (400) de traitement de signaux, et pour délivrer en sortie un signal ayant un résultat d'addition,

où ledit moyen (300) de génération de bruit comprend:

un moyen de quantification de non-uniformité (351) pour quantifier le signal introduit audit moyen (300) de génération de bruit de manière non-uniforme par rapport à un niveau correspondant, et pour délivrer en sortie un signal résultant;
un moyen de dé-quantification (361) pour exécuter un traitement opposé à un traitement exécuté par ledit moyen (351) de quantification de non-uniformité sur le signal provenant dudit moyen de quantification de non-uniformité (351), et pour délivrer en sortie un signal résultant, et
un moyen de soustraction (371) pour générer et délivrer en sortie un signal de bruit quantifié (302) du signal introduit audit moyen (300) de génération de bruit en calculant la différence entre le signal introduit audit moyen (300) de génération de bruit et le signal provenant dudit moyen (361) de dé-quantification.

4. Appareil (100) d'extension de bandes de signaux audio selon l'une quelconque des revendications 1 à 3, comprenant en plus:

un premier moyen de conversion (130) prévu de manière à être inséré à l'étage précédent dudit moyen (200) de filtrage passe-bande, ledit premier moyen de conversion (130) convertissant le signal introduit (101) en un signal numérique; et
un deuxième moyen de conversion (131) prévu de manière à être inséré entre ledit moyen (400) de traitement de signaux et ledit moyen d'addition (800), ledit deuxième moyen de conversion (131) convertissant le signal (102) délivré en sortie dudit moyen (400) de traitement de signaux en un signal analogique.

5. Appareil (100) d'extension de bandes de signaux audio selon l'une quelconque des revendications 1 à 3, comprenant en plus:

un moyen (120) de filtrage passe-bas de type à sur-échantillonnage prévu de manière à être inséré à l'étage précédent dudit moyen (200) de filtrage passe-bande et ledit moyen d'addition (800), ledit moyen (120) de filtrage passe-bas de type à sur-échantillonnage effectuant un sur-échantillonnage et un filtrage passe-bas du signal introduit (101), et délivrant en sortie un signal résultant audit moyen (200) de filtrage passe-bande et audit moyen d'addition (800).

6. Appareil (100) d'extension de bandes de signaux audio selon l'une quelconque des revendications 1 à 3, comprenant en plus:

un moyen (120) de filtrage passe-bas de type à sur-échantillonnage prévu de manière à être inséré à l'étage précédent dudit moyen d'addition (800), ledit moyen (120) de filtrage passe-bas de type à sur-échantillonnage effectuant un sur-échantillonnage et un filtrage passe-bas du signal introduit (101), et délivrant en sortie un signal résultant audit moyen d'addition (800); et
un moyen de sur-échantillonnage (101) prévu de manière à être inséré entre ledit moyen (300) de génération de bruit et ledit moyen (400) de traitement de signaux, ledit moyen de sur-échantillonnage (121) effectuant un sut-écliantillonnage du signal de bruit provenant dudit moyen (300) de génération de bruit, et délivrant en sortie un signal résultant audit moyen (400) de traitement de signaux.

7. Appareil (100) d'extension de bandes de signaux audio selon la revendication 1,
dans lequel ledit moyen (320) de génération de signaux de bruit blanc comprend un quantificateur (20) du type à modulateur delta-sigma, génère un signal de bruit quantifié (303) d'un signal introduit audit moyen (320) de génération de signaux de bruit blanc, et délivre en sortie un signal de bruit quantifié (303) généré en tant que signal de bruit blanc.

8. Appareil (100) d'extension de bandes de signaux audio selon la revendication 2, dans lequel ledit deuxième moyen de coupe exécute une coupe de l'une ou l'autre d'une combinaison d'un ensemble de bits d'ordre intermédiaire et un ensemble de bits d'ordre inférieur, et un ensemble de deux bits d'ordre inférieur, à des emplacements différents de bits et avec une largeur de bits prédéterminée, en additionnant des bits coupés, et délivre en sortie un signal ayant un résultat d'addition.

9. Appareil (100) d'extension de bandes de signaux audio selon la revendication 2, dans lequel ledit deuxième moyen de coupe exécute une coupe de l'une ou l'autre d'une combinaison d'un ensemble de bits d'ordre intermédiaire et un ensemble de deux bits d'ordre inférieur, et un ensemble de trois bits d'ordre inférieur, à des emplacements différents de bits et avec une largeur de bits prédéterminée, en additionnant des bits coupés, et délivre en sortie un signal ayant un résultat d'addition.

10. Appareil (100) d'extension de bandes de signaux audio selon la revendication 2, comprenant en plus:

   un moyen (300) de génération de bruit indépendant pour générer un signal de bruit indépendant du signal introduit (101); et
   un moyen d'addition supplémentaire (800) pour additionner le signal de bruit provenant dudit deuxième moyen de coupe et le signal de bruit provenant dudit moyen (300) de génération de bruit indépendant, et pour délivrer en sortie un signal ayant un résultat d'addition audit moyen de multiplication (340).

11. Appareil (100) d'extension de bandes de signaux audio selon la revendication 10, dans lequel ledit moyen (300) de génération de bruit indépendant génère une pluralité de signaux de bruit différents les uns des autres, additionne ladite pluralité de signaux de bruit, et délivre en sortie un signal ayant un résultat d'addition.

12. Appareil (100) d'extension de bandes de signaux audio selon la revendication 10 ou 11, dans lequel ledit moyen (300) de génération de bruit indépendant génère un signal de bruit de tramage en diamant.

13. Appareil (100) d'extension de bandes de signaux audio selon la revendication 3, dans lequel ledit moyen (351) de quantification de non-uniformité quantifie un signal introduit (101) de manière à augmenter une largeur de quantification étant donné qu'un niveau du signal introduit (101) est plus grand.

14. Appareil (100) d'extension de bandes de signaux audio selon la revendication 3 ou 13, dans lequel ledit moyen (351) de quantification de non-uniformité comprime une longueur de plage d'un code linéaire de L bits en 1/N de celle-ci de manière à générer et à délivrer en sortie des données de M bits, où L, M et N sont des nombres entiers positifs chacun desquels est supérieur ou égal à 2.

15. Appareil (100) d'extension de bandes de signaux audio selon l'une quelconque des revendications 3, 13 et 14, dans lequel ledit moyen (351) de quantification de non-uniformité convertit un code linéaire de L bits qui est composé de données continues $Q0$ de bits continus chacun ayant une logique prédéterminée et étant attribué dans une partie d'ordre supérieur, un bit inversé $T0$ qui coupe la continuité des données continues $Q0$, et des données d'ordre inférieur $D0$ suivant le bit inversé $T0$, en données comprimées de M bits se composant de données continues comprimées $Q1$ obtenues en comprimant une longueur de plage des données continues $Q0$, un bit inversé $T1$ pour couper ainsi la continuité des données continues comprimées $Q1$, des données résiduelles comprimées $F1$ représentant un résidu généré lors de la compression de la longueur de plage, et des données de mantisse $D1$ obtenues en arrondissant les données d'ordre inférieur $D0$, et délivre en sortie les données comprimées de M bits, et où, à condition que la longueur de plage des données continues $Q0$ soit $L0$, une longueur de plage des données continues comprimées $Q1$ soit $L1$, et que N soit un nombre entier supérieur ou égal à 2, la longueur de plage $L1$ des données continues comprimées $Q1$ et les données résiduelles comprimées $F1$ sont exprimées par $L1 = Int(L0/N)$ et $F1 = L0 \bmod N$, respectivement, où Int est une fonction qui représente une valeur d'un nombre entier d'un argument, et $A \bmod B$ est une fonction qui représente un résidu obtenu lorsque A est divisé par B.

16. Appareil (100) d'extension de bandes de signaux audio selon l'une quelconque des revendications 3, 13 et 14, dans lequel ledit moyen (361) de dé-quantification agrandit des données comprimées qui sont composées de données continues comprimées Q1 de bits continus chacun ayant une logique prédéterminée et étant attribué dans une partie d'ordre supérieur, un bit inversé T1 qui coupe la continuité des données continues comprimées Q1, les données résiduelles comprimées F1 représentant un résidu généré lors de la compression d'une longueur de plage des données continues comprimées Q1, et des données de mantisse D1, en étendant la longueur de plage des données continues comprimées Q1 par "N fois", en additionnant des données continues ayant une longueur correspondant à une valeur des données F1, en additionnant un bit inversé T0 qui coupe la continuité de Q0, en additionnant en plus les données de mantisse D1 à des données résultantes, en lisant les données continues Q0, le bit inversé T0, et les données de mantisse D0, et en délivrant en sortie des données étendues, et

où, à condition qu'une longueur de plage des données continues Q0 soit L0, une longueur de plage desdites données continues comprimées Q1 soit L1, un résidu obtenu à partir des données résiduelles comprimées F1 soit F 1, et N soit un nombre entier supérieur ou égal à 2, la longueur de plage L0 et les données de mantisse D0 sont exprimées par L0 = L1*n + F1 et D0 = D1, respectivement, où * est un symbole arithmétique représentant la multiplication.

17. Appareil (100) d'extension de bandes de signaux audio selon l'une quelconque des revendications 3 et 13 à 16, dans lequel ledit moyen (351) de quantification de non-uniformité exécute un codage flottant d'un code linéaire introduit en un code flottant ayant une longueur de bits efficace prédéterminée, et délivre en sortie un signal codé ayant le code flottant.

18. Appareil (100) d'extension de bandes de signaux audio selon l'une quelconque des revendications 1 à 17, dans lequel ledit moyen (300) de génération de bruit comprend:

   un moyen de mémoire à table pour stocker une relation entre le signal introduit audit moyen (300) de génération de bruit et un signal de bruit corrélé au niveau du signal introduit audit moyen (300) de génération de bruit de manière à changer selon un niveau du signal introduit audit moyen (300) de génération de bruit; et
   un moyen de conversion pour, en réponse au signal introduit audit moyen (300) de génération de bruit, lire et délivrer en sortie un signal de bruit correspondant au signal introduit audit moyen (300) de génération de bruit à partir dudit moyen de mémoire à table

19. Appareil (100) d'extension de bandes de signaux audio selon l'une quelconque des revendications 1 à 18, dans lequel ledit moyen (400) de traitement de signaux comprend au moins un premier moyen de filtrage, et dans lequel ledit moyen (400) de traitement de signaux élimine par filtrage des bandes de fréquences supérieures à une bande de fréquence du signal introduit (101).

20. Appareil (100) d'extension de bandes de signaux audio selon l'une quelconque des revendications 1 à 19, dans lequel ledit moyen (400) de traitement de signaux comprend au moins (1/f) moyen de filtrage, et dans lequel ledit moyen (400) de traitement de signaux applique une (1/f) caractéristique de réduction à un spectre de bandes de fréquences supérieur du signal introduit audit moyen (400) de traitement de signaux.

21. Appareil (100) d'extension de bandes de signaux audio selon l'une quelconque des revendications 1 à 20, dans lequel ledit moyen (400) de traitement de signaux comprend au moins un moyen de traitement par addition d'écho, et dans lequel ledit moyen (400) de traitement de signaux additionne un signal d'écho à un spectre de bandes de fréquences supérieur du signal introduit audit moyen (400) de traitement de signaux.

22. Appareil (100) d'extension de bandes de signaux audio selon l'une quelconque des revendications 1 à 21, dans lequel ledit moyen (400) de traitement de signaux comprend au moins un deuxième moyen de filtrage, et dans lequel ledit moyen (400) de traitement de signaux élimine par filtrage des bandes de fréquences supérieures à une bande de fréquences du signal introduit audit moyen (400) de traitement de signaux de manière à inclure des bandes de fréquences dépassant une fréquence de Nyquist.

*Fig.1*

AUDIO BAND EXTENSION APPARATUS 100-1

INPUTTED SIGNAL X

101

200

BPF

300

LEVEL CORRELATED WHITE NOISE GENERATOR CIRCUIT

301

400

SIGNAL PROCESSING CIRCUIT

302

800

+ (+) +

OUTPUTTED SIGNAL W

102

EP 1 653 627 B1

## Fig.2

AUDIO BAND EXTENSION APPARATUS 100-2

INPUTTED
SIGNAL X

101

800

+
⊕
+

OUTPUTTED
SIGNAL W

102

130

A/D
CONVERTER

200

BPF

300

LEVEL CORRELATED
WHITE NOISE
GENERATOR CIRCUIT

400

SIGNAL
PROCESSING
CIRCUIT

131

D/A
CONVERTER

301

302

EP 1 653 627 B1

# Fig.3

AUDIO BAND EXTENSION APPARATUS 100-3

INPUTTED SIGNAL X — 101 → [ 120 OVERSAMPLING TYPE LPF ] → → [ + 800 + ] → OUTPUTTED SIGNAL W — 102

[ 200 BPF ] → 301 → [ 300 LEVEL CORRELATED WHITE NOISE GENERATOR CIRCUIT ] → 302 → [ 400 SIGNAL PROCESSING CIRCUIT ]

EP 1 653 627 B1

*Fig.4*

AUDIO BAND EXTENSION APPARATUS 100-4

INPUTTED SIGNAL X

OUTPUTTED SIGNAL W

120 — OVERSAMPLING TYPE LPF

800

101

102

200 — BPF

300 — LEVEL CORRELATED WHITE NOISE GENERATOR CIRCUIT

121 — OVERSAMPLING CIRCUIT

400 — SIGNAL PROCESSING CIRCUIT

301

302

EP 1 653 627 B1

## Fig.5

OVERSAMPLING TYPE LPF 120

11 — OVERSAMPLING CIRCUIT

12 — LPF

*Fig.6*

EP 1 653 627 B1

## Fig.7

LEVEL CORRELATED WHITE NOISE GENERATOR CIRCUIT 300-1

EP 1 653 627 B1

# Fig.8

WHITE NOISE SIGNAL GENERATOR CIRCUIT <u>320</u>

20

FIRST-ORDER DELTA SIGMA
MODULATOR TYPE QUANTIZER

22

FROM BPF 200 ○——— + ⊕ 21 ——————•——→ QUANTIZER

−

301

24

$z^{-1}$ ←——•——— + ⊕
−

303 23

○ TO MULTIPLIER 340

QUANTIZED NOISE SIGNAL

EP 1 653 627 B1

## Fig.9

LEVEL CORRELATED WHITE NOISE GENERATOR CIRCUIT 300-2

311

HIGHER-ORDER BITS
CUTTING-OUT CIRCUIT

340

MULTIPLIER

321

LOWER-ORDER BITS
CUTTING-OUT CIRCUIT

301

302

EP 1 653 627 B1

## Fig.10

LEVEL CORRELATED WHITE NOISE GENERATOR CIRCUIT 300-3

311

HIGHER-ORDER BITS
CUTTING-OUT CIRCUIT

340

MULTIPLIER

301

302

331

INTERMIDIATE-ORDER BITS
CUTTING-OUT CIRCUIT

330

+

+

321

LOWER-ORDER BITS
CUTTING-OUT CIRCUIT

EP 1 653 627 B1

*Fig.11*

LEVEL CORRELATED WHITE NOISE GENERATOR CIRCUIT 300-4

EP 1 653 627 B1

## Fig.12

LEVEL CORRELATED WHITE NOISE GENERATOR CIRCUIT 300-5

311

HIGHER-ORDER BITS
CUTTING-OUT CIRCUIT

340

MULTIPLIER

301

321

LOWER-ORDER BITS
CUTTING-OUT CIRCUIT

330

380

INDEPENDENT
WHITE NOISE
GENERATOR CIRCUIT

302

EP 1 653 627 B1

*Fig.13*

INDEPENDENT WHITE NOISE GENERATOR CIRCUIT 380

30−1 — PN SEQUENCE NOISE SIGNAL GENERATOR CIRCUIT

30−2 — PN SEQUENCE NOISE SIGNAL GENERATOR CIRCUIT

30−3 — PN SEQUENCE NOISE SIGNAL GENERATOR CIRCUIT

30−N — PN SEQUENCE NOISE SIGNAL GENERATOR CIRCUIT

31

33

32 — CONSTANT SIGNAL GENERATOR FOR DC OFFSET REMOVAL

EP 1 653 627 B1

*Fig.14*

32-BIT COUNTER 41

MSB(31ST BIT)

42

7TH BIT

------

3RD BIT

2ND BIT

1ST BIT

LSB(0TH BIT)

8

PN SEQUENCE
NOISE SIGNAL

32

CLOCK SIGNAL
GENERATOR  43

INITIAL VALUE
DATA
GENERATOR  44

EP 1 653 627 B1

## Fig.15

LEVEL CORRELATED WHITE NOISE GENERATOR CIRCUIT 300-6

311

HIGHER-ORDER BITS CUTTING-OUT CIRCUIT

301

321

LOWER-ORDER BITS CUTTING-OUT CIRCUIT

330

340

MULTIPLIER

302

381

DIAMOND DITHERING NOISE GENERATOR CIRCUIT

EP 1 653 627 B1

## Fig.16A

MSB　　　　　　　　　　　　　　　　　　　　　　　LSB

| b P 0 | b 1 | b 2 | b 3 | b 4 | b 5 | b 6 | b 7 | b 8 | b 9 | b 10 | b 11 | b 12 | b 13 | b 14 | b 15 | b 16 | b 17 | b 18 | b 19 | b 20 | b 21 | b 22 | b 23 |
|---|---|---|---|---|---|---|---|---|---|---|---|---|---|---|---|---|---|---|---|---|---|---|---|

CUTTING-OUT OF HIGHER-ORDER BITS　　　　　　　　　　　CUTTING-OUT OF LOWER-ORDER BITS

## Fig.16B

MSB　　　　　　　　　　　　　　　　　　　　　　　LSB

| b P 0 | b 1 | b 2 | b 3 | b 4 | b 5 | b 6 | b 7 | b 8 | b 9 | b 10 | b 11 | b 12 | b 13 | b 14 | b 15 | b 16 | b 17 | b 18 | b 19 | b 20 | b 21 | b 22 | b 23 |
|---|---|---|---|---|---|---|---|---|---|---|---|---|---|---|---|---|---|---|---|---|---|---|---|

CUTTING-OUT OF HIGHER-ORDER BITS

CUTTING-OUT OF LOWER-ORDER BITS

EP 1 653 627 B1

EP 1 653 627 B1

*Fig.17A*

MSB

LSB

| b 0 P | b 1 | b 2 | b 3 | b 4 | b 5 | b 6 | b 7 | b 8 | b 9 | b 10 | b 11 | b 12 | b 13 | b 14 | b 15 | b 16 | b 17 | b 18 | b 19 | b 20 | b 21 | b 22 | b 23 |
|---|---|---|---|---|---|---|---|---|---|---|---|---|---|---|---|---|---|---|---|---|---|---|---|

CUTTING-OUT OF
HIGHER-ORDER BITS

CUTTING-OUT OF
INTERMIDIATE-
ORDER BITS

CUTTING-OUT OF
LOWER-ORDER BITS

*Fig.17B*

MSB

LSB

| b 0 P | b 1 | b 2 | b 3 | b 4 | b 5 | b 6 | b 7 | b 8 | b 9 | b 10 | b 11 | b 12 | b 13 | b 14 | b 15 | b 16 | b 17 | b 18 | b 19 | b 20 | b 21 | b 22 | b 23 |
|---|---|---|---|---|---|---|---|---|---|---|---|---|---|---|---|---|---|---|---|---|---|---|---|

CUTTING-OUT OF
HIGHER-ORDER BITS

CUTTING-OUT OF
LOWER-ORDER
BITS

CUTTING-OUT OF
LOWER-ORDER
BITS

CUTTING-OUT OF
LOWER-ORDER
BITS

## Fig.18A

PROBABILITY DENSITY OF WHITE NOISE SIGNAL AT N=1

AMPLITUDE LEVEL

0

## Fig.18B

PROBABILITY DENSITY OF DIAMOND NOISE SIGNAL AT N=2

AMPLITUDE LEVEL

0

## Fig.18C

PROBABILITY DENSITY OF BELL NOISE SIGNAL AT N=3

AMPLITUDE LEVEL

0

## Fig.19

LEVEL CORRELATED WHITE NOISE GENERATOR CIRCUIT 300-7

371

+

301     +

302

−

351                          361

NON-UNIFORMITY
QUANTIZER          →        DEQUANTIZER

EP 1 653 627 B1

EP 1 653 627 B1

*Fig.20*

LEVEL CORRELATED WHITE NOISE GENERATOR CIRCUIT 300-8

## Fig.21

# Fig.22

## Fig.23A

DATA FORMAT BEFORE RUN LENGTH
1/4 COMPRESSION FLOATING CODING

POLARITY   CONTINUOUS   INVERTED
BIT          DATA          BIT        DATA

| P | Q0 | T0 | D0 |

L0

L

## Fig.23B

DATA FORMAT AFTER RUN LENGTH
1/4 COMPRESSION FLOATING CODING

COMPRESSED   COMPRESSED
CONTINUOUS    RESIDUAL
   DATA          DATA
POLARITY   INVERTED       MANTISSA
BIT          BIT          DATA

| P | Q1 | T1 | F1 | D1 |

L1

M

## Fig.24

LEVEL CORRELATED WHITE NOISE GENERATOR CIRCUIT 300-9

390

TABLE CONVERTER
CIRCUIT

TABLE MEMORY

301

302

390a

## Fig.25

SIGNAL PROCESSING CIRCUIT 400

BPF410

411

412

420

430

| HPF | → | 1/f CHARACTERISTIC FILTER | → | ECHO ADDITION CIRCUIT | → | |

COMMAND SIGNAL FOR INDICATING CUT-OFF CHARACTERISTIC AT LOW FREQUENCY SIDE

CONTROL SIGNAL

CONTROL SIGNAL

EP 1 653 627 B1

## Fig.26

## Fig.27

## Fig.28

ECHO ADDITION CIRCUIT <u>420</u>

Fig.29A   SIGNAL LEVEL OF
          INPUTTED SIGNAL X

Fig.29B   SIGNAL LEVEL OF
          OUTPUTTED SIGNAL
          FROM LPF 120

Fig.29C   SIGNAL LEVEL OF
          OUTPUTTED SIGNAL
          FROM CIRCUIT 300

Fig.29D   SIGNAL LEVEL OF
          OUTPUTTED SIGNAL
          FROM CIRCUIT 400

Fig.29E   SIGNAL LEVEL OF
          OUTPUTTED SIGNAL W

*Fig.30A*

SIGNAL LEVEL OF
INPUTTED SIGNAL X

*Fig.30B*

SIGNAL LEVEL OF
OUTPUTTED SIGNAL
FROM CIRCUIT 300

*Fig.30C*

SIGNAL LEVEL OF
OUTPUTTED SIGNAL
FROM CIRCUIT 400

*Fig.30D*

SIGNAL LEVEL OF
OUTPUTTED SIGNAL W

## Fig.31A

SIGNAL LEVEL OF
INPUTTED SIGNAL X

## Fig.31B

SIGNAL LEVEL OF OUTPUTTED
SIGNAL FROM LPF 120

200S

## Fig.31C

SIGNAL LEVEL OF OUTPUTTED
SIGNAL FROM CIRCUIT 300

## Fig.31D

SIGNAL LEVEL OF OUTPUTTED
SIGNAL FROM CIRCUIT 400

## Fig.31E

SIGNAL LEVEL OF
OUTPUTTED SIGNAL W

*Fig.32A*

SIGNAL LEVEL OF
INPUTTED SIGNAL X

200S

0

$f_{max}$    fs    FREQUENCY

*Fig.32B*

SIGNAL LEVEL OF OUTPUTTED
SIGNAL FROM CIRCUIT 300

0

2fs    4fs

FREQUENCY

*Fig.32C*

SIGNAL LEVEL OF OUTPUTTED
SIGNAL FROM CIRCUIT 400

0

$f_{max}$    2fs    4fs

FREQUENCY

*Fig.32D*

SIGNAL LEVEL OF
OUTPUTTED SIGNAL W

0

$f_{max}$    2fs    4fs

FREQUENCY

## Fig.33A

SIGNAL LEVEL
IN CHARACTERISTIC
OF ALIASING REMOVAL FILTER

0

0          2fs          4fs

FREQUENCY

## Fig.33B

SIGNAL LEVEL OF
OUTPUTTED SIGNAL W

0

0    $f_{max}$          2fs          4fs

FREQUENCY

*Fig.34*

EP 1 653 627 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0070769 A
- EP 0706299 A
- JP 4286421 A
- JP 5183445 A
- JP 5284039 A